# EUROPEAN PATENT SPECIFICATION

(11) **EP 3 826 173 B1**
(45) Date of publication and mention of the grant of the patent: **02.07.2025**
(21) Application number: 19837408.4
(22) Date of filing: 19.07.2019
(51) Int. Cl.: H03F 3/02, H03F 3/20, H02M 3/00, H03F 3/21, H03F 1/02, H03F 1/52, H03F 3/24, H03F 3/68, H03F 3/72, H02M 1/32, H02M 1/36

(54) **POWER SUPPLY APPARATUS AND METHOD FOR POWER AMPLIFIER**
STROMVERSORGUNGSVORRICHTUNG UND VERFAHREN FÜR LEISTUNGSVERSTÄRKER
APPAREIL D'ALIMENTATION ÉLECTRIQUE ET PROCÉDÉ D'AMPLIFICATEUR DE PUISSANCE

(30) Priority: 19.07.2018 CN 201810797983
(43) Date of publication of application: 26.05.2021
(73) Proprietor: ZTE Corporation, Shenzhen Guangdong 518057 (CN)
(72) Inventor: LI, Xiangfeng, Guangdong 518057 (CN); LI, Changlang, Shenzhen, Guangdong 518057 (CN); ZENG, Jixiang, Shenzhen, Guangdong 518057 (CN); LIU, Zhong, Shenzhen, Guangdong 518057 (CN); SUN, Wenchang, Shenzhen, Guangdong 518057 (CN); XIAO, Huanqing, Shenzhen, Guangdong 518057 (CN); ZHANG, Jinchao, Shenzhen, Guangdong 518057 (CN)
(74) Representative: WBH Wachenhausen Patentanwälte PartG mbB
(86) International application number: PCT/CN2019/096887
(87) International publication number: WO 2020/015755

(56) References cited:
- CN-A- 102 412 815
- CN-A- 102 931 956
- CN-A- 103 296 981
- CN-A- 103 368 750
- CN-A- 107 528 553
- CN-U- 206 164 492
- CN-U- 206 211 954
- CN-U- 207 304 494
- CN-U- 207 529 257
- US-A1- 2007 236 292
- US-A1- 2014 118 074
- CHEEMA N ET AL: "Design and implementation of bias sequence circuits for GaN HEMT amplifiers both pulsed and CW applications", APPLIED SCIENCES AND TECHNOLOGY (IBCAST), 2013 10TH INTERNATIONAL BHURBAN CONFERENCE ON, IEEE, 15 January 2013 (2013-01-15), pages 420 - 423, XP032390753, ISBN: 978-1-4673-4425-8, DOI: 10.1109/IBCAST.2013.6512193

## Description

### TECHNICAL FIELD

The present application relates to, but is not limited to, the field of base station communication, in particular to a power supply apparatus and method for a power amplifier.

### BACKGROUND

As the base station communication technology develops rapidly, the requirements for radiofrequency power amplifiers in base stations are getting higher and higher. A gallium nitride (GaN) power amplifier, which features broad band, high saturated electron mobility, higher breakdown voltage, capability to withstand higher temperature, higher power capacity and the like, has gradually become a key electronic component for radio frequency amplification in a communication base station.

However, the GaN power amplifier has strict power-on and power-off timing requirements, i.e., a gate voltage must be powered on earlier than a drain voltage and powered off later than the drain voltage. If the power supply of the GaN power amplifier does not satisfy the power-on and power-off timing requirements, the power-on or power-off is in a short-circuit state, such that the GaN power amplifier is easily burnt. Due to high cost of the GaN power amplifier, a lot of loss in cost will be caused if the GaN power amplifier is burnt.

How to ensure the reliability in power supply timing of a power amplifier in a base station is a problem to be solved. However, there is still a need of effective scheme for this problem in related technologies.

Patent literature CN207529257U discloses a gaN HEMT power tube grid drains and adds electric chronogenesis protection bias circuit, add electric chronogenesis protective film piece, the positive negative pressure conversion module of grid, voltage regulator module and voltage follower including the grid drain electrode, the positive negative pressure conversion module of grid passes through negative pressure steady voltage chip, and will to import positive voltage conversion be the negative voltage to carry out filtering through the RC circuit, the REG pin of negative pressure steady voltage chip provides TTL high level signal for the grid, and the output signal of REG pin controls with the electricity leaking to press through NPN triode, N channel MOSFET and P channel MOSFET, when the output of grid power supply negative pressure was abnormal, REG provided the high level, and P channel MOSFET turn -offs, does not drain, the grid power supply negative pressure is exported just often, and the REG pin provides the low level, and the P channel MOSFET switch on, in the drain electrode.

Patent literature CN107528553A discloses a GaN power amplifying tube bias protection circuit comprises a GaN power amplifying tube, a gate voltage stabilizing circuit A, a gate voltage regulating circuit B, a voltage following circuit C, and a gate-drain power-on sequence protection circuit D, wherein the gate voltage stabilizing circuit comprises a voltage stabilizing chip U1; a +5V power supply is connected to the chip U1, and a REG pin end of the chip U1 is connected with an input end of the gate-drain power-on sequence protection circuit D; an output end of the gate-drain power-on sequence protection circuit D is connected with a drain of the GaN power amplifying tube; an OUT pin of the chip U1 is connected with an input end of the gate voltage regulating circuit B and an input end of the voltage following circuit C; an output end of the voltage following circuit C is connected with a gate of the GaN power amplifying tube; and the gate-drain power-on sequence protection circuit D is further connected with a system drain power supply Vd_IN.

Patent literature US 2014/118074 A1 provides a power amplifier controller for starting up, operating, and shutting down a power amplifier. The power amplifier controller includes current sense amplifier circuitry adapted to monitor a main current of the power amplifier. A bias generator is also included and adapted to provide a predetermined standby bias voltage and an operational bias voltage based upon a main current level sensed by the current sense amplifier circuitry. The power amplifier controller further includes a sequencer adapted to control startup and shutdown sequences of the power amplifier. In at least one embodiment, the power amplifier is a gallium nitride (GaN) device, and the main current level sensed is a drain current of the GaN device. Moreover, the bias generator is a gate bias generator provided that the power amplifier is a field effect transistor (FET) device.

Patent literature CN207304494U discloses a protective circuit for protection gallium nitride power device, protective circuit includes: switch sequential circuit, switch sequential circuit is used for the protection the gallium nitride power device, temperature compensation circuit, temperature compensation circuit is used for doing protective circuit realizes temperature compensating, constant voltage constant current circuit, constant voltage constant current circuit is used for making the constant current of protective circuit constant voltage.

Patent literature CN206164492U discloses a gaN power amplifier pulse modulation circuit, including power -on sequence control circuit, grid voltage temperature compensation circuit and drain electrode pulse modulation circuit, wherein, power -on sequence control circuit respectively with grid voltage temperature compensation circuit and drain electrode pulse modulation circuit connection, the output of grid voltage temperature compensation circuit and drain electrode pulse modulation circuit respectively with the grid of gaN power amplifier with leak the level and be connected, power -on sequence control circuit is used for producing burden voltage input extremely grid voltage temperature compensation circuit to and produce the enable signal input extremely drain electrode pulse modulation circuit, grid voltage temperature compensation circuit is used for according to the temperature production gaN power amplifier of negative voltage and the gaN power amplifier of the input required grid voltage of normally working, drain electrode pulse modulation circuit is used for producing drain electrode pulse modulation voltage according to the enable signal of input and TTL pulse signal.

Patent literature CN102931956A relates to a design implementing method capable of simultaneously improving efficiencies and reliability of a gallium nitride (GaN) power tube. According to the design implementing method, by means of a negative electricity protection circuit, sequential control of a power supply of the power tube is achieved, and the reliability of the power tube is improved; and simultaneously, pulse modulation is performed to drain positive electricity so that quiescent current is cut off when the power tube doesn't work.

Cheema N et al disclose in Paper entitled "Design and Implementation of Bias Sequence Circuits for GaN HEMT Amplifiers both Pulsed and CW Applications" that, they have design and implemented the sequential circuits in bias network for pulsed and CW applications. MAX881R is used in power supply for pulsed while LTI1964ES5-BYP with R2D Recon 2405 is used for high current application in CW. For pulsed applications in ON sequence the gate is turned-on ~ 220 ms before the drain, while in OFF sequence the drain is turned-off ~ 1.7s before the gate. While in CW applications in ON sequence the gate is turned-on ~ 130ms before the drain and in OFF sequence, the drain is turned-off ~ 633ms before the gate.

Patent literature CN206211954U discloses a 9~10GHz high-power solid-state amplifier assembly, which comprises a front amplifier, a power distributor, six final amplifiers and a power supply module. The input end of the front-stage amplifier is used to connect the input radio frequency signal, and the output end of the front-stage amplifier is connected with a power distributor, which is provided with six output ends, which are respectively connected with six final-stage amplifiers, and each final-stage amplifier is provided with six output ends for outputting radio frequency signals, and the power supply module is used to provide working voltages to be respectively output to the front-stage amplifier, the power distributor and the final-stage amplifier.

While the above publications may achieve their intended purposes, there is still a need for a new and improved power supply apparatus and method for a power amplifier.

### SUMMARY

Embodiments of the present application provide a power supply apparatus and method for a power amplifier, which at least achieve the reliability in power supply timing of a power amplifier in a base station.

The invention is set out in the appended claims.

According to an embodiment of the present application, a power supply apparatus for a power amplifier includes a first power circuit, a second power circuit, a gate voltage circuit, an enable circuit, a redundant circuit, a power-off holding circuit and a detection and control circuit, where the redundant circuit is connected to the first power circuit, the second power circuit, the power-off holding circuit and the gate voltage circuit, and configured to supply an input voltage to the power-off holding circuit after performing redundancy on an output voltage of the first power circuit and an output voltage of the second power circuit, and to supply an input voltage to the gate voltage circuit after performing redundancy on the output voltage of the first power circuit and an output voltage of the power-off holding circuit; the power-off holding circuit is connected to the gate voltage circuit, and configured to provide power-off energy holding and power-off delay to a gate voltage output by the gate voltage circuit; and the detection and control circuit is connected to the power-off holding circuit, the gate voltage circuit and the enable circuit, and configured to inspect the power-off holding circuit during a power-on process, to detect a voltage of the power-off holding circuit and a voltage of the gate voltage circuit during a normal operation and a power-off process, and to realize, by enable control of the enable circuit, where a detection result satisfies a judgment condition, that power-on of the gate voltage is earlier than power-on of a drain voltage output by the second power circuit and that power-off of the gate voltage is later than power-off of the drain voltage output by the second power circuit.

According to an embodiment of the present application, a power supply method for a power amplifier includes: generating, by a redundant circuit, a first redundant backup voltage after performing redundancy on an output voltage of a first power circuit and an output voltage of a second power circuit, to supply an input voltage to a power-off holding circuit; generating, by the redundant circuit, a second redundant backup voltage after performing redundancy on the output voltage of the first power circuit and an output voltage of the power-off holding circuit, to supply an input voltage to the gate voltage circuit; and inspecting, by a detection and control circuit, the power-off holding circuit during a power-on process; detecting a voltage of the power-off holding circuit and a voltage of the gate voltage circuit during a normal operation and a power-off process; and realizing, by enable control of an enable circuit, where a detection result satisfies a judgment condition, that power-on of the gate voltage output by the gate voltage circuit is earlier than power-on of a drain voltage output by the second power circuit and power-off of the gate voltage output by the gate voltage circuit is later than power-off of the drain voltage output by the second power circuit.

### BRIEF DESCRIPTION OF DRAWINGS

FIG. 1 is an architecture diagram of an application scenario provided by an embodiment of the present application;
FIG. 2 is a schematic diagram of components of a power supply apparatus for a power amplifier provided by an embodiment of the present application;
FIG. 3 is a flowchart of a power supply method for a power amplifier provided by an embodiment of the present application;
FIG. 4 is a flowchart of another power supply method for the power amplifier provided by an embodiment of the present application;
FIG. 5 is a flowchart of yet another power supply method for the power amplifier provided by an embodiment of the present application;
FIG. 6 is a schematic structural diagram of a power supply apparatus for a power amplifier provided by an embodiment of the present application;
FIG. 7 is a schematic structural diagram of another power supply apparatus for the power amplifier provided by an embodiment of the present application;
FIG. 8 is a schematic structural diagram of another power supply apparatus for the power amplifier provided by an embodiment of the present application;
FIG. 9 is a schematic structural diagram of another power supply apparatus for the power amplifier provided by an embodiment of the present application;
FIG. 10 is a schematic structural diagram of still another power supply apparatus for the power amplifier provided by an embodiment of the present application;
FIG. 11 is a schematic structural diagram of still another power supply apparatus for a power amplifier provided by an embodiment of the present application;
FIG. 12 is a schematic structural diagram of still another power supply apparatus for the power amplifier provided by an embodiment of the present application;
FIG. 13 is a flowchart of power-on control in a power supply method for a power amplifier provided by an embodiment of the present application;
FIG. 14 is a flowchart of power-off control in a power supply method for a power amplifier provided by an embodiment of the present application;
FIG. 15 is a control flowchart showing that a channel is abnormal when a power supply apparatus for a power amplifier provided by an embodiment of the present application is in normal operation;
FIG. 16 is a circuit diagram of one power supply apparatus for a power amplifier provided by an embodiment of the present application; and
FIG. 17 is a circuit diagram of a plurality of power supply apparatuses for a power amplifier provided by an embodiment of the present application.

### DETAILED DESCRIPTION

The present application is explained with reference to the accompanying drawings and embodiments. The embodiments provided herein are intended to explain the present application but are not intended to limit the present application. In addition, the following embodiments are provided as some of the embodiments for implementing the present application, but are not provided as all of the embodiments for implementing the present application.

In the embodiments of the present application, the terms "include", "contain" or any other variation thereof, are intended to encompass a non-exclusive inclusion, such that a method or apparatus comprising a series of elements includes not only the elements expressly recited, but also other elements not expressly listed, or elements inherent to the method or apparatus being practiced. Without more limitations, for an element defined by the statement "include a...", the method or apparatus comprising the element is not excluding but may have additional relevant elements (e.g., a step in the method or unit in the apparatus, e.g., the unit may be part of a circuit, part of a processor, part of a program or software, etc.).

For example, the power supply method for a power amplifier provided in the embodiments of the present application includes a series of steps. However, the power supply method for a power amplifier provided in the embodiments of the present application is not limited to the described steps. The power supply apparatus for a power amplifier provided in the embodiments of the present application includes a series of components, but the power supply apparatus for a power amplifier provided in the embodiments of the present application is not limited to the explicitly described components.

The term "first\second" in the embodiments of the present application is merely a distinction between similar objects and does not represent a particular order of objects. The term "first\second" may interchange a particular order or order of precedence, if allowed. Objects distinguished by the term "first\second" may be interchangeable where appropriate to enable embodiments of the present application to be implemented in order other than the order illustrated or described herein.

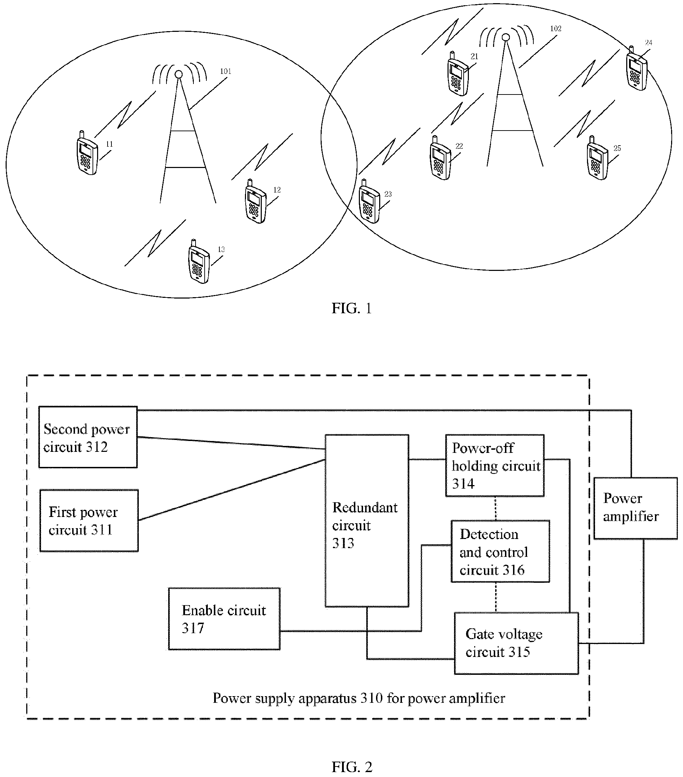

An application scenario of a power supply method for a power amplifier of the present application is shown in FIG. 1, including: a base station 101 and a base station 102. There are three terminals, namely a terminal 11, a terminal 12, and a terminal 13 in a cell coverage area of the base station 101. There are five terminals, namely, a terminal 21, a terminal 22, a terminal 23, a terminal 24, and a terminal 25 in a cell coverage area of the base station 102. Each terminal may be a mobile phone terminal as shown in FIG. 1, or may be one or more Internet of Things (IoT) terminals. A network element device (e.g., a base station) has strict power-on and power-off timing requirements on a GaN power amplifier, i.e., a gate voltage must be powered on earlier than a drain voltage and powered off later than the drain voltage.

In related technologies, there are mainly three schemes for realizing the reliability in supplying power to the base station: the first scheme is realized by an electronic switch circuit; the second scheme is realized by a discharge circuit; and the third scheme is realized by a dedicated timing control chip or a single chip microcomputer or a controller. In the first scheme realized by the electronic switch circuit, before a drain voltage is supplied to the power amplifier, the electronic switch circuit is controlled by a gate voltage, and an electronic switch cannot be turned on until the gate voltage is established. The electronic switch is turned off immediately once the gate voltage is powered off. The first scheme has many problems in terms of the reliability. Especially in the case of self-excitation or an abnormally large signal or high power of the power amplifier, the power supply in a previous stage will be restarted after being turned off, which easily exceeds a safe operating area (SOA) curve of the electronic switch and damages the electronic switch. Therefore, the reliability is mediocre. In the second scheme achieved by the discharge circuit, when the gate voltage is not powered off, the reliability in supplying power is achieved by discharging the drain voltage. However, a reference voltage comparison point of the discharge circuit is susceptible to interference and abnormalities, which easily causes high-voltage discharge and results in damage to the electronic switch of the discharge circuit. Therefore, the reliability is mediocre. In the third scheme achieved by a dedicated timing control chip or a single-chip microcomputer, depending on the timing control chip or a controller in the single-chip microcomputer, the timing cannot be under controlled when the controller is abnormal. Therefore, the reliability in supplying power cannot be guaranteed and there are limitations.

These three schemes are not high in reliability due to respective shortcomings. If the reliability in power-on and power-off timing of the power amplifier cannot be guaranteed, the power amplifier is easily brought into a short-circuit state when being powered on or powered off, such that the power amplifier is easily burnt. The power amplifier will cause a lot of loss in cost if it burns out due to high cost. A power supply apparatus for a power amplifier provided by an embodiment of the present application includes a gate voltage circuit, an enable circuit, a redundant circuit, a power-off holding circuit and a detection and control circuit. The redundant circuit is connected to a first power circuit, a second power circuit, the power-off holding circuit and the gate voltage circuit, and configured to supply an input voltage to the power-off holding circuit after performing redundancy on an output voltage of the first power circuit and an output voltage of the second power circuit, and to supply an input voltage to the gate voltage circuit after performing redundancy on the output voltage of the first power circuit and an output voltage of the power-off holding circuit. The power-off holding circuit is connected to the gate voltage circuit, and configured to provide power-off energy holding and power-off delay to a gate voltage output by the gate voltage circuit. The detection and control circuit is connected to the power-off holding circuit, the gate voltage circuit and the enable circuit, and configured to inspect the power-off holding circuit during a power-on process, to detect a voltage of the power-off holding circuit and a voltage of the gate voltage circuit during a power-off process, and to realize, where a detection result satisfies a judgment condition, by means of enable control of the enable circuit, that power-on of the gate voltage is earlier than power-on of a drain voltage output by the second power circuit, and that power-off of the gate voltage is later than power-off of the drain voltage output by the second power circuit. Since the power-off holding circuit and the gate voltage circuit can be continuously powered by the energy that can be stored redundantly and by using the redundant circuit, signals can be subjected to enable control based on a detection result during the power-on and power-off processes, such that power-on of the gate voltage is earlier than power-on of the drain voltage output by the second power circuit and power-off of the gate voltage is later than power-off of the drain voltage output by the second power circuit, thereby ensuring power-on holding and power-off delay and thus realizing the reliability in power supply timing of the power amplifier.

An embodiment of the present application provides a power supply apparatus for a power amplifier. As shown in FIG. 2, the power supply apparatus 310 for the power amplifier includes a first power circuit 311, a second power circuit 312, a redundant circuit 313, a power-off holding circuit 314, a gate voltage circuit 315, a detection and control circuit 316, and an enable circuit 317. The redundant circuit 313 is configured to supply an input voltage to the power-off holding circuit 314 after performing redundancy an output voltage of the first power circuit (a 1^{st} power circuit) 311 and an output voltage of the second power circuit (a P1^{st} power circuit) 312. The first power circuit (the 1^{st} power circuit) 311 supplies power to a digital load of a base station. The second power circuit (the P1^{st} power circuit) 312 supplies power to a drain of a power amplifier. The redundant circuit 313 is further configured to supply an input voltage to the gate voltage circuit 315 after performing redundancy on the output voltage of the first power circuit (the 1^{st} power circuit) 311 and an output voltage of the power-off holding circuit 314. The power-off holding circuit 314 is configured to provide power-off energy holding and power-off delay to a gate voltage output by the gate voltage circuit. The gate voltage circuit is configured to generate a gate voltage for the power amplifier and to supply power to a gate of the power amplifier. The detection and control circuit 316 is configured to inspect the power-off holding circuit during the power-on process, such that the reliability of the power-off process can be ensured at the beginning of the power-on process. The detection and control circuit 316 is also configured to detect (may be configured to detect in real time) a voltage of the power-off holding circuit 314 and a voltage of the gate voltage circuit 315 during a normal operation and a power-off process; and, to output, where a detection result satisfies a judgment condition, an output signal to the enable circuit by means of the enable control of the enable circuit 317 (i.e., after logical judgment processing of the detection result and the judgment condition), so as to control the enable circuit to realize that power-on of the gate voltage is earlier than power-on of a drain voltage output by the second power circuit and power-off of the gate voltage is later than power-off of the drain voltage output by the second power circuit. That is, the energy redundancy conversion of one or more drain voltages of the power amplifier is fully utilized during the power-off process, to fully delay the power-off holding circuit, thereby ensuring that the power-off of the gate voltage is later than power-off of the drain voltage.

In a practical application, the first power circuit (such as the 1^{st} power circuit) is powered on to supply power to the digital load of the base station. The redundancy is performed on the output voltage of the first power circuit (such as the 1^{st} power circuit) and the output voltage of the second power circuit (such as the P1^{st} power circuit) to supply power to the power-off holding circuit, and meanwhile the redundancy is performed on the output voltage of the power-off holding circuit and the output voltage of the first power circuit (such as the 1^{st} power circuit) to supply power to the gate voltage circuit. By detecting the output voltage of the power-off holding circuit and output voltages of the 1^{st} to n^{th} gate voltage circuits, after a logical judgment, the output voltage of the second power circuit (such as the P1^{st} power circuit) can be subjected to enable control, thereby realizing that power-on of the gate voltage output by the gate voltage circuit is earlier than power-on of the drain voltage output by the second power circuit (such as the P1^{st} power circuit). During the power-on process, the gate voltage is generated by the redundant circuit (in one embodiment, by a redundant backup circuit) to enable the drain of the power amplifier to be turned on. A gate voltage is generated redundantly again after the drain voltage is powered on. The detection and control circuit is configured to inspect the power-off holding circuit during the power-on process, such that the reliability of the power-off process can be ensured at the beginning of the power-on process. The energy redundancy conversion of one or more drain voltages of the power amplifier is fully utilized during the power-off process, to fully delay the power-off holding circuit, thereby ensuring that the power-off of the gate voltage is later than power-off of the drain voltage. Since power-off energy holding and power-off delay are achieved, the power-off of the gate voltage is later than power-off of the drain voltage, thereby solving the problem in terms of the reliability in power supply timing of the power amplifier. The present application can reliably and effectively guarantee the power supply requirements of the GaN power amplifier no matter any power channel fails, or any power channel is powered on or off before or after other power channels, or an abnormal situation occurs during the normal operation.

The redundancy refers to the realization of "OR" power supply of a plurality of voltages, that is, selectively supplying power, where the plurality of voltages does not affect each other, and the normal operation of the system can be guaranteed as long as at least one of the voltages is normal.

Compared with the traditional implementation scheme, the power supply apparatus for the power amplifier according to the embodiment of the present application is more compact and reliable, can be widely used in a wireless communication base station device of the 4th Generation mobile communication system (4G) or the 5th generation mobile communication system (5G), is highly versatile and has a wide range of application values.

In one embodiment, the redundant circuit includes a first redundant circuit (a redundant circuit 1) and a second redundant circuit (a redundant circuit 2). A first input terminal of the first redundant circuit (the redundant circuit 1) is connected to an output terminal of the first power circuit (the 1^{st} power circuit). A second input terminal of the first redundant circuit (the redundant circuit 1) is connected to an output terminal of the second power circuit (the P1^{st} power circuit). An output terminal of the first redundant circuit (the redundant circuit 1) is connected to an input terminal of the power-off holding circuit, and configured to supply an input voltage to the power-off holding circuit. The first power circuit (the 1^{st} power circuit) supplies power to a digital load of a base station. The second power circuit (the P1^{st} power circuit) supplies power to a drain of the power amplifier.

In one embodiment, the redundant circuit further includes the second redundant circuit (a redundant circuit 2). A first input terminal of the second redundant circuit (the redundant circuit 2) is connected to an output terminal of the first power circuit (the 1^{st} power circuit). A second input terminal of the second redundant circuit (the redundant circuit 2) is connected to an output terminal of the power-off holding circuit. An output terminal of the second redundant circuit (the redundant circuit 2) is connected to the gate voltage circuit (a 1^{st} gate voltage circuit), and configured to supply an input voltage to the gate voltage circuit.

In one embodiment, the gate voltage circuit is configured to generate a gate voltage for the power amplifier and to supply power to a gate of the power amplifier.

In one embodiment, a first input terminal of the detection and control circuit is connected to the output terminal of the power-off holding circuit; a second input terminal of the detection and control circuit is connected to an output terminal of the gate voltage circuit; and an output terminal of the detection and control circuit is connected to an input terminal of the enable circuit.

In one embodiment, an output terminal of the enable circuit is connected to an enable control circuit of the second power circuit (the P1^{st} power circuit), and configured to perform start control on the second power circuit (the P1^{st} power circuit).

Based on the above embodiments, in a practical application, the power supply apparatus for the power amplifier may include a 1^{st} power circuit, a P1^{st} power circuit, a redundant circuit 1, a power-off holding circuit 2, a redundant circuit 2, a gate voltage circuit, a detection and control circuit and an enable circuit. The 1^{st} power circuit supplies power to the digital load of the base station; and the P1^{st} power circuit supplies power to a drain of a GaN power amplifier. The power-off holding circuit is configured to provide power-off energy holding and power-off delay to a gate voltage output by the gate voltage circuit, where an input terminal of the power-off holding circuit is connected to an output terminal of the redundant circuit 1, and an output terminal of the power-off holding circuit is connected to an input terminal of the redundant circuit 2. In one embodiment, the redundant circuit 2 is configured to provide power-off energy holding and power-off delay to a gate voltage, where one input terminal of the redundant circuit 2 is connected to an output terminal of the 1^{st} power circuit, the other input terminal of the redundant circuit 2 is connected to the output terminal of the power-off holding circuit, and an output terminal of the redundant circuit 2 is connected to an input terminal of a 1^{st} gate voltage circuit. The gate voltage circuit is configured to generate a gate voltage for the GaN power amplifier and to supply power to a gate of a P1^{st} GaN power amplifier. One input terminal of the detection and control circuit is connected to the output terminal of the power-off holding circuit; and the other input terminal of the detection and control circuit is connected to the output terminal of the gate voltage circuit. After logic processing, an output signal of the detection and control circuit controls the enable circuit. The enable circuit is configured to control the start of the P1^{st} power circuit, where an input terminal of the enable circuit is connected to the output terminal of the detection and control circuit, and an output terminal of the enable circuit is connected to an enable control circuit of the P1^{st} power circuit.

In one embodiment, the first power circuit (the 1^{st} power circuit) includes one power supply or multiple power supplies. For example, the power supplied by the 1^{st} power circuit to a load of a digital part, may not be limited to one power supply, but may be 1^{st} to m^{th} power supplies.

In one embodiment, the second power circuit (the P1^{st} power circuit) includes one power supply or multiple power supplies. For example, the power supplied by the P1^{st} power circuit to the power amplifier, may not be limited to one power supply, but can be the P1^{st} to Pn^{th} power supplies.

In one embodiment, an input source of the first power circuit (the 1^{st} power circuit) is the same as that of the second power circuit (the P1^{st} power circuit); or an input source of the first power circuit (the 1^{st} power circuit) is different from that of the second power circuit (the P1^{st} power circuit). For example, the input sources of 1^{st} to m^{th} power supplies and of P1^{st} to Pn^{th} power supplies can be the same or different.

In one embodiment, the first power circuit (the 1^{st} power circuit) and the second power circuit (the P1^{st} power circuit) both connected to the first redundant circuit (the redundant circuit 1), is a combination of at least one from a plurality of power supplies. For example, the first power circuit connected to the redundant circuit 1 may be one, several or all of the 1^{st} to m^{th} power supplies, and one, several or all of the P1^{st} to Pn^{th} power supplies. The redundant circuit 1 can be implemented as an electronic switch, a diode, a relay, a switch circuit or the like.

In one embodiment, the first power circuit (the 1^{st} power circuit) connected to the second redundant circuit (the redundant circuit 2) includes one power supply or at least one from a plurality of power supplies. For example, the first power circuit connected to the redundant circuit 2 may be one, several or all of the 1^{st} to m^{th} power supplies. The redundant circuit 2 is configured to perform redundancy on the output voltage of the first power circuit and the output voltage of the power-off holding circuit, and supply energy to the gate voltage circuit.

In one embodiment, the implementation form of the power-off holding circuit includes: a boost circuit of a wide input range, a step-down circuit of a wide input range, other conversion energy storage circuit or an energy storage element.

In one embodiment, the implementation form of the gate voltage circuit includes: one or more of a plurality of power amplifiers. For example, one or more of the 1^{st} to n^{th} power amplifiers supply a gate voltage, and the implementation form of the gate voltage circuit can be flexibly configured according to load power of the gate voltage.

The present embodiment further provides a power supply method for a power amplifier. This method is implemented based on the above-mentioned power supply apparatus for the power amplifier, which will not be repeated because it has been described in the present application.

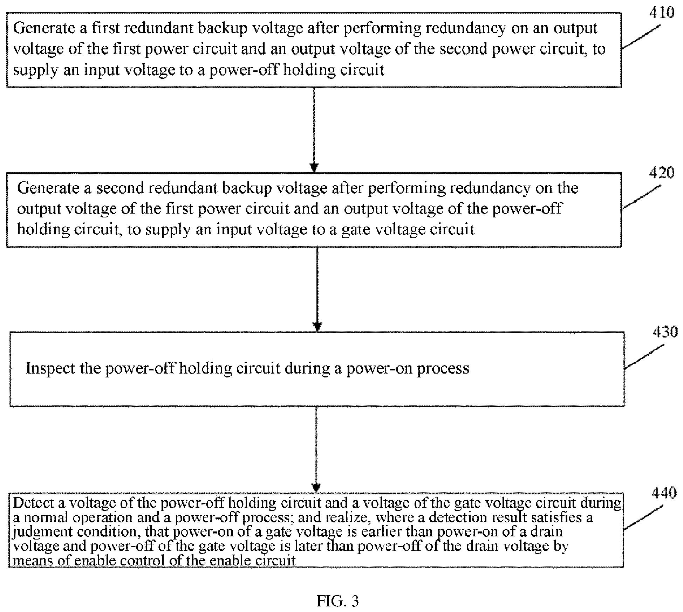

In a present embodiment of the present application, as shown in FIG. 3, a power supply method for the power amplifier includes steps 410-440.

At step 410, a first redundant backup voltage is generated after performing redundancy on an output voltage of the first power circuit and an output voltage of the second power circuit, to supply an input voltage to the power-off holding circuit.

A first redundant backup voltage is generated after performing redundancy on an output voltage of the 1^{st} power circuit and an output voltage of the P1^{st} power circuit, to supply an input voltage to the power-off holding circuit.

At step 420, a second redundant backup voltage is generated after performing redundancy on the output voltage of the first power circuit and an output voltage of the power-off holding circuit, to supply an input voltage to the gate voltage circuit.

A second redundant backup voltage is generated after performing redundancy on the output voltage of the 1^{st} power circuit and the output voltage of the power-off holding circuit, to supply an input voltage to the gate voltage circuit.

At step 430, the power-off holding circuit is inspected during the power-on process.

At step 440, a voltage of the power-off holding circuit and a voltage of the gate voltage circuit are detected during a normal operation and a power-off process, to realize, where a detection result satisfies a judgment condition, that power-on of a gate voltage is earlier than power-on of a drain voltage and power-off of the gate voltage is later than power-off of the drain voltage, by means of enable control.

In the present embodiment, the gate voltage is output by the gate voltage circuit, and the drain voltage is output by the second power circuit.

The output voltage of the power-off holding circuit and the output voltage of the gate voltage circuit are detected (may be detected in real time) during the normal operation and the power-off process.

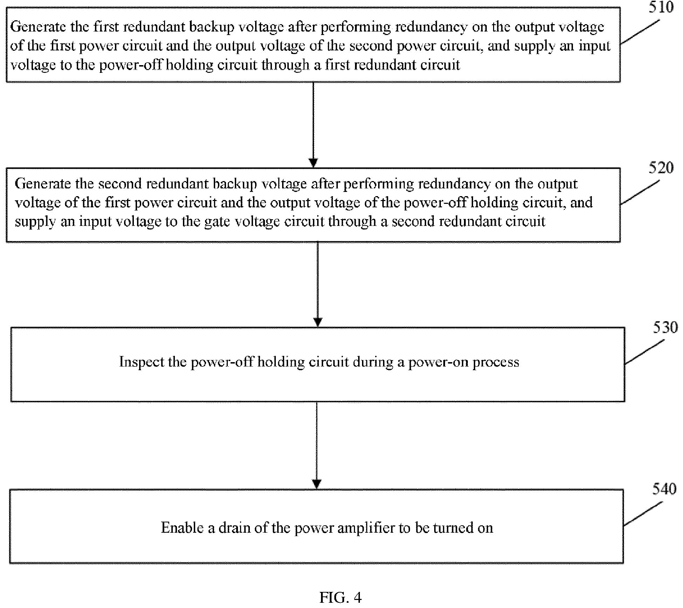

According to a power supply method for a power amplifier in an embodiment of the present application, the first redundant backup voltage is stored in the first redundant circuit (the redundant circuit 1), and the second redundant backup voltage is stored in the second redundant circuit (the redundant circuit 2). As shown in FIG. 4, the method includes the following steps 510-540.

At step 510, a first redundant backup voltage is generated after performing redundancy on an output voltage of the first power circuit and an output voltage of the second power circuit, and an input voltage is supplied to the power-off holding circuit through the first redundant circuit (the redundant circuit 1).

A first redundant backup voltage is generated after performing redundancy on an output voltage of the 1^{st} power circuit and an output voltage of the P1^{st} power circuit, as an input voltage supplied to the power-off holding circuit.

At step 520, a second redundant backup voltage is generated after performing redundancy on the output voltage of the first power circuit and an output voltage of the power-off holding circuit, and an input voltage is supplied to the gate voltage circuit through the second redundant circuit (the redundant circuit 2).

A second redundant backup voltage is generated after performing redundancy on the output voltage of the 1^{st} power circuit and the output voltage of the power-off holding circuit, as an input voltage supplied to the gate voltage circuit.

At step 530, the power-off holding circuit is inspected during the power-on process.

When it is detected that any one of the output voltage of the power-off holding circuit and the output voltage of the gate voltage circuit is abnormal, an abnormal signal is output.

When it is detected that any one of the output voltage of the power-off holding circuit and the output voltage of the gate voltage circuit is abnormal, the power-off process is performed and the abnormality is inspected.

When it is detected that each of the output voltage of the power-off holding circuit and the output voltage of the gate voltage circuit is normal, the enable circuit is controlled to be valid to enable the second power circuit (the P1^{st} power circuit) to be powered on.

At step 540, a drain of the power amplifier is enabled to be turned on.

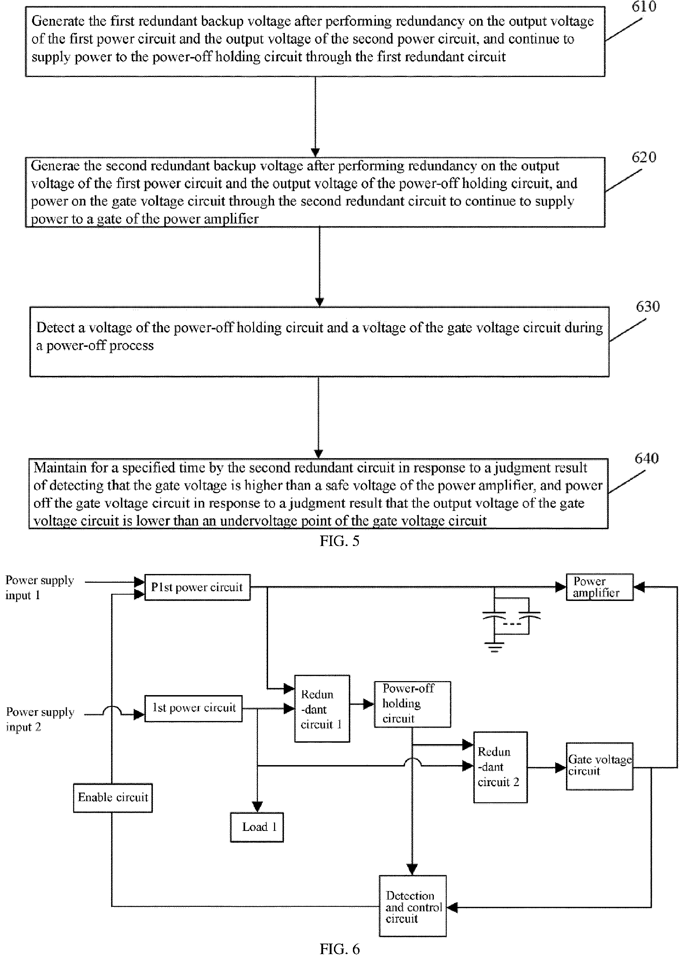

According to a power supply method for a power amplifier in an embodiment of the present application, the first redundant backup voltage is stored in the first redundant circuit (the redundant circuit 1), and the second redundant backup voltage is stored in the second redundant circuit (the redundant circuit 2). As shown in FIG. 5, the method includes the following steps 610-640.

At step 610, a first redundant backup voltage is generated after performing redundancy on an output voltage of the first power circuit and an output voltage of the second power circuit, and the power-off holding circuit is continued to be supplied with power through the first redundant circuit (the redundant circuit 1).

A first redundant backup voltage is generated after performing redundancy on an output voltage of the 1^{st} power circuit and an output voltage of the P1^{st} power circuit, to continue to supply power to the power-off holding circuit.

At step 620, a second redundant backup voltage is generated after performing redundancy on the output voltage of the first power circuit and an output voltage of the power-off holding circuit, and the gate voltage circuit is powered on through the second redundant circuit (the redundant circuit 2), so as to continue to supply power to a gate of the power amplifier.

A second redundant backup voltage is generated after performing redundancy on the output voltage of the 1^{st} power circuit and the output voltage of the power-off holding circuit, to continue to supply power to the gate voltage circuit.

At step 630, a voltage of the power-off holding circuit and a voltage of the gate voltage circuit are detected during the power-off process.

A detection is performed to judge whether the gate voltage is higher than a safe voltage of the power amplifier, and in response to a judgment result of a detection that the gate voltage is higher than the safe voltage of the power amplifier, the gate voltage circuit is subsequently powered off.

At step 640, the power supplied to the gate voltage circuit is maintained for a specified time by the second redundant circuit (the redundant circuit 2) in response to the judgment result of the detection that the gate voltage is higher than the safe voltage of the power amplifier; and the gate voltage circuit is powered off in response to a judgment result that the output voltage of the gate voltage circuit is lower than an undervoltage point of the gate voltage circuit.

In a practical application, the 1^{st} power circuit is powered on to supply power to the digital load of the base station. The redundancy is performed on the output voltage of the 1^{st} power circuit and the output voltage of the P1^{st} power circuit to supply power to the power-off holding circuit, and meanwhile the redundancy is performed on the output voltage of the power-off holding circuit and the output voltage of the 1^{st} power circuit to supply power to the gate voltage circuit. By detecting the output voltage of the power-off holding circuit and output voltages of 1^{st} to n^{th} gate voltage circuits, after making a logical judgment, the output voltage of the P1^{st} power circuit can be subjected to enable control, thereby realizing that power-on of a gate voltage output by the gate voltage circuit is earlier than power-on of a drain voltage output by the P1^{st} power circuit. That is, the energy stored in a drain voltage power circuit of the P1^{st} power circuit is sufficiently utilized and subjected to redundancy to generate the first redundant backup voltage, which is then supplied to the power-off holding circuit, thereby providing a stable power-off holding circuit. The first redundant backup voltage which is generated by performing redundancy on the 1^{st} power circuit and the power-off holding circuit again is supplied to the gate voltage circuit, thereby providing a reliable gate voltage circuit and ensure the reliability in power-off delay under any conditions.

By implementing the embodiment of the present application, the power-on process is not affected by the input voltage of the 1^{st} power circuit and the input voltage of the P1^{st} power circuit, and has no mandatory requirement on a power-on sequence for the 1^{st} power circuit and the P1^{st} power circuit. The redundant circuit and the detection and control circuit ensure that the P1^{st} power circuit is enabled if the output voltage of the gate voltage circuit is normal, which reliably realizes the normal power-on requirements of the GaN power amplifier. Meanwhile, the power-off holding circuit is inspected during the power-on process, and the output of the P1^{st} power circuit cannot be started if an abnormality is identified. The power-off holding circuit is inspected at the instant of power-on, which ensures that the power-on and power-off timing is more reliable. The P1^{st} to Pn^{th} power circuits are powered off when input sources of the P1^{st} to Pn^{th} power circuits are powered off. The power-off holding circuit can ensure that the drain voltage of the GaN power amplifier falls within a safe voltage area of the SOA curve, and then sufficient delay of 1^{st} to n^{th} gate voltage circuits in lower input ensures that the gate voltage is powered off at last. In the case that any one of the P1^{st} to Pn^{th} power circuits is abnormal, the redundant circuit, the power-off holding circuit and the gate voltage circuit will not lose power, thereby ensuring the reliability in supplying power. The power supplies of the P1^{st} to Pn^{th} power circuits do not affect each other, and are applicable to a power amplifier of a multi-channel base station, thereby ensuring the reliability in supplying power.

The power supply apparatus for a power amplifier according to the embodiments of the present application may be implemented by software, and the software (such as a computer program) may be stored in a memory, which may be a volatile memory or a non-volatile memory, or may include both a volatile memory and a non-volatile memory. The non-volatile memory may be a read only memory (ROM), a programmable read only memory (PROM), an erasable programmable read only memory (EPROM), an electrically erasable programmable read only memory (EEPROM), a ferromagnetic random access memory (FRAM), a flash memory, a magnetic surface memory, an optical disc, or a compact disc read only memory (CD-ROM). The magnetic surface storage may be a magnetic disk storage or a magnetic tape storage. The volatile memory may be a random access memory (RAM) that functions as an external cache. By way of example, but not limitation, many forms of RAM may be used, such as static random access memory (SRAM), synchronous static random access memory (SSRAM), dynamic random access memory (DRAM), synchronous dynamic random access memory (SDRAM), double data rate synchronous dynamic random access memory (DDRSDRAM), enhanced synchronous dynamic random access memory (ESDRAM), syncLink dynamic random access memory (SLDRAM), direct rambus random access memory (DRRAM). The memory described in the embodiments of the present application is intended to include, but is not limited to, the memory already described in the present application and any other suitable type of memory.

An embodiment of the present application provides a computer-readable storage medium, configured to store a calculation program provided in the above embodiments, in order to complete the steps of the above methods. The computer-readable storage medium may be a memory such as FRAM, ROM, PROM, EPROM, EEPROM, Flash Memory, magnetic surface memory, optical disk, or CD-ROM; also may be one or more devices including one or any combination of the above memories.

Alternative embodiments of the present application will be described below with reference to the accompanying drawings.

The enable circuit in the embodiments of the present application may be a generating circuit of an x^{th} power supply, or any electronic switching circuit before and after a Px power supply, which is not limited to the description of the enable circuit in the following embodiments.

### Alternative Embodiment One

FIG. 6 is a schematic structural diagram of a power supply apparatus for a power amplifier provided by an embodiment of the present application. In this schematic diagram, there is only one power amplifier and only one digital power supply. A 1^{st} power circuit supplies power to a digital load of a base station, and a P1^{st} power circuit supplies power to a power amplifier. An output voltage of the 1^{st} power circuit and an output voltage of the P1^{st} power circuit supply power to a power-off holding circuit through a redundant circuit 1, and an output voltage of the power-off holding circuit and the output voltage of the 1^{st} power circuit supply power to a gate voltage circuit through a redundant circuit 2. By detecting a voltage of the power-off holding circuit and voltages of 1^{st} to n^{th} gate voltage circuits, if a judgment condition is satisfied after a logical judgment, the output voltage of the P1^{st} power circuit supplies power to the power amplifier by means of enable control.

### Alternative Embodiment Two

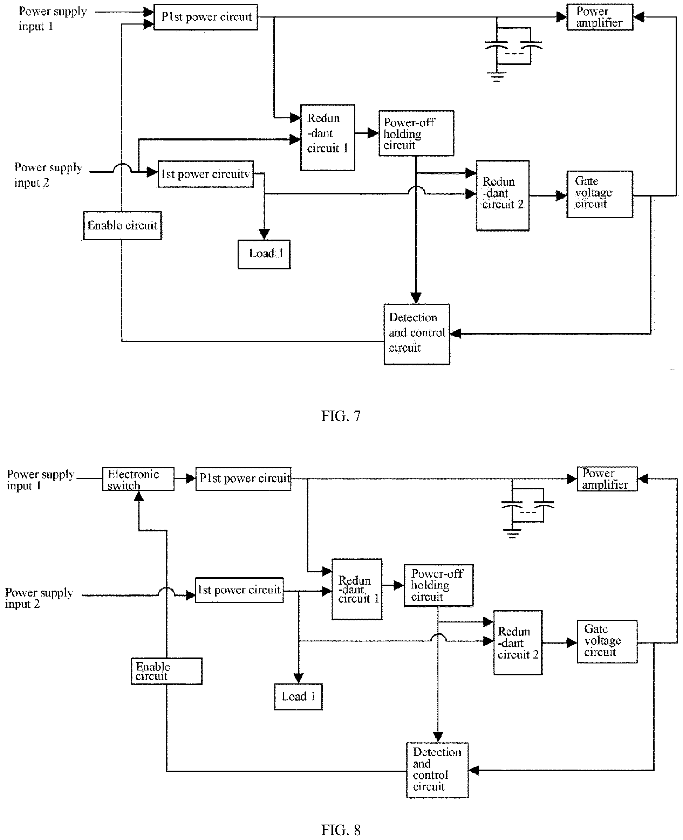

FIG. 7 is a schematic structural diagram of another power supply apparatus for the power amplifier provided by an embodiment of the present application. This schematic diagram is the same as FIG. 6 except that an input voltage of a redundant circuit 1 is optional, which may be an input voltage of a 1^{st} power circuit or an output voltage of the 1^{st} power circuit. In one embodiment, the 1^{st} power circuit supplies power to a digital load of a base station, and a P1^{st} power circuit supplies power to a power amplifier. An input voltage of the 1^{st} power circuit and an output voltage of the P1^{st} power circuit supply power to a power-off holding circuit through the redundant circuit 1; or an output voltage of the 1^{st} power circuit and the output voltage of the P1^{st} power circuit supply power to the power-off holding circuit through the redundant circuit 1. An output voltage of the power-off holding circuit and the output voltage of the 1^{st} power circuit supply power to a gate voltage circuit through a redundant circuit 2. By detecting a voltage of the power-off holding circuit and voltages of1^{st} to n^{th} gate voltage circuits, if a judgment condition is satisfied after a logical judgment, the output voltage of the P1^{st} power circuit supplies power to a power amplifier by means of enable control.

### Alternative Embodiment Three

FIG. 8 is a schematic structural diagram of yet another power supply apparatus for the power amplifier provided by an embodiment of the present application. The content shown in FIG. 8 is the same as that described in FIG. 6 except that an enable circuit can enable an electronic switch in front of a P1^{st} power circuit. In one embodiment, a 1^{st} power circuit supplies power to a digital load of a base station, and the P1^{st} power circuit supplies power to a power amplifier. An output voltage of the 1^{st} power circuit and an output voltage of the P1^{st} power circuit supply power to a power-off holding circuit through a redundant circuit 1, and an output voltage of the power-off holding circuit and the output voltage of the 1^{st} power circuit supply power to a gate voltage circuit through a redundant circuit 2. By detecting the input voltage of the power-off holding circuit and output voltages of 1^{st} to n^{th} gate voltage circuits, if a judgment condition is satisfied after a logical judgment, the output voltage of the P1^{st} power circuit supplies power to the power amplifier by means of enable control. The enable circuit is connected to the P1^{st} power circuit through an electronic switch, an input terminal of the P1^{st} power circuit is connected to an output terminal of the electronic switch, and the enable circuit can enable the electronic switch in front of the P1^{st} power circuit.

### Alternative Embodiment Four

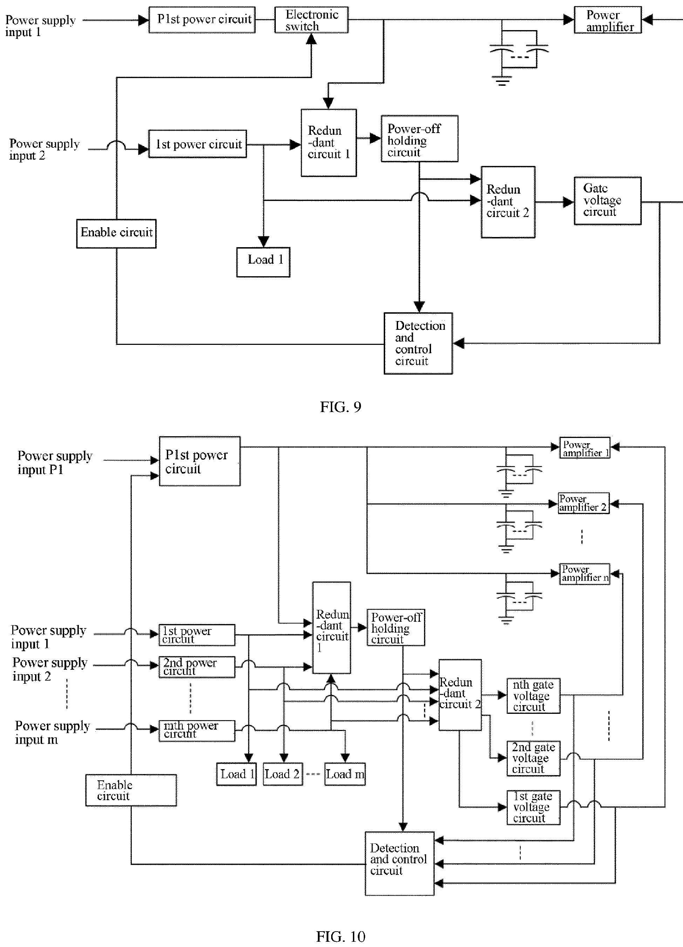

FIG. 9 is a schematic structural diagram of still another power supply apparatus for a power amplifier provided by an embodiment of the present application. The content shown in FIG. 9 is consistent with that described in FIG. 6 except that an enable circuit can enable an electronic switch behind a P1^{st} power circuit. In one embodiment, a 1^{st} power circuit supplies power to a digital load of a base station, and the P1^{st} power circuit supplies power to a power amplifier. An output voltage of the 1^{st} power circuit and an output voltage of the P1^{st} power circuit supply power to a power-off holding circuit through a redundant circuit 1, and an output voltage of the power-off holding circuit and the output voltage of the 1^{st} power circuit supply power to a gate voltage circuit through f a redundant circuit 2. By detecting a voltage of the power-off holding circuit and voltages of 1^{st} to n^{th} gate voltage circuits, if a judgment condition is satisfied after a logical judgment, the output voltage of the P1^{st} power circuit supplies power to the power amplifier by means of enable control. The enable circuit is connected to the P1^{st} power circuit through an electronic switch, an input terminal of the P1^{st} power circuit is connected to an input terminal of the electronic switch, and the enable circuit can enable the electronic switch behind the P1^{st} power circuit.

### Alternative Embodiment Five

FIG. 10 is a schematic structural diagram of still another power supply apparatus for the power amplifier provided by an embodiment of the present application. The content shown in FIG. 10 is consistent with that described in FIG. 7 except that the inputs of a redundant circuit 1 in this schematic diagram are output voltages of 1^{st}, 2^{nd}, ..., m^{th} power circuits and an output voltage of a P1^{st} power circuit; the inputs of a redundant circuit 2 in this schematic diagram are output voltages of 1^{st}, 2^{nd}, ..., m^{th} power circuits and an output voltage of a power-off holding circuit; and the output of the redundant circuit 2 in this schematic diagram generates input voltages of 1^{st}, 2^{nd}, ..., n^{th} gate voltage circuits.. In one embodiment, the 1^{st}, 2^{nd}, ..., m^{th} power circuits supply power a digital load of a base station, and the P1^{st} power circuit supplies power to the power amplifier. The output voltages of the 1^{st}, 2^{nd}, ..., m^{th} power circuits and the output voltage of the P1^{st} power circuit supply power to the power-off holding circuit through a redundant circuit 1; and the output voltage of the power-off holding circuit and the output voltages of the 1^{st}, 2^{nd}, ..., m^{th} power circuits supply power to a gate voltage circuit through a redundant circuit 2; and an output of the redundant circuit 2 generates input voltages of 1^{st}, 2^{nd}, ..., m^{th} gate voltage circuits. By detecting a voltage of the power-off holding circuit and voltages of 1^{st} to n^{th} gate voltage circuits, if a judgment condition is satisfied after a logical judgment, the output voltage of the P1^{st} power circuit supplies power to a power amplifier by means of enable control.

### Alternative Embodiment Six

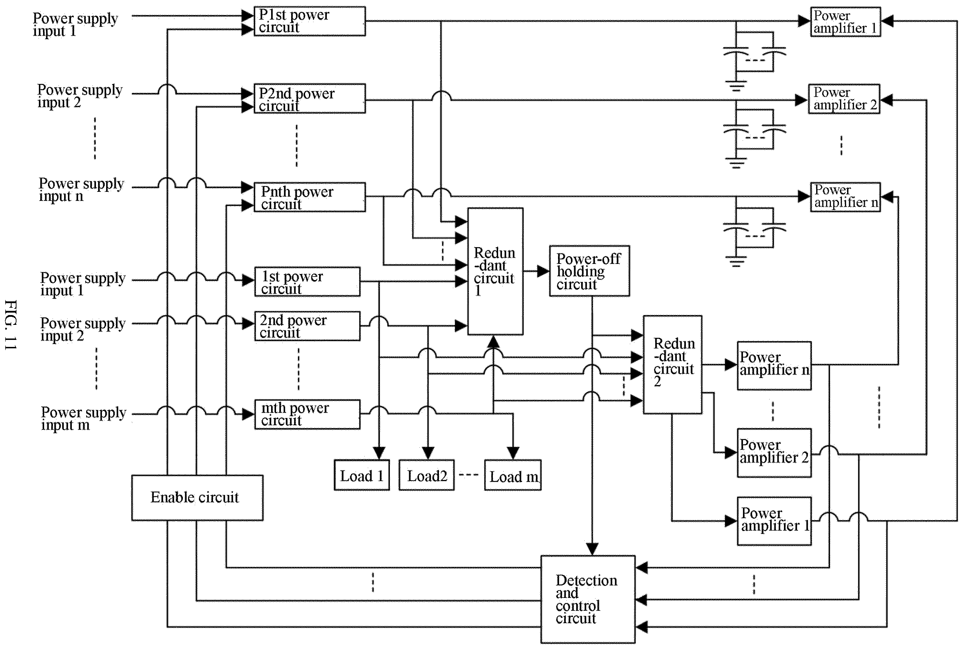

FIG. 11 is a schematic structural diagram of still another power supply apparatus for the power amplifier provided by an embodiment of the present application. The content shown in FIG. 11 is consistent with that described in FIG. 7 except that the inputs of a redundant circuit 1 in this schematic diagram are output voltages of 1^{st}, 2^{nd}, ..., m^{th} power circuits and output voltages of P1^{st}, P2^{nd}, ..., Pn^{th} power circuits; the inputs of a redundant circuit 2 in this schematic diagram are output voltages of 1^{st}, 2^{nd}, ..., m^{th} power circuits and an output voltage of a power-off holding circuit; and the output of the redundant circuit 2 in this schematic diagram generates input voltages of 1^{st}, 2^{nd}, ..., n^{th} gate voltage circuits. In one embodiment, the 1^{st}, 2^{nd}, ..., m^{th} power circuits supply power a digital load of a base station, and the P1^{st}, P2^{nd}, ..., Pn^{th} power circuits supply power to the power amplifier. The output voltages of the 1^{st}, 2^{nd}, ..., m^{th} power circuits and the output voltages of the P1^{st}, P2^{nd}, ..., Pn^{th} power circuits supply power to the power-off holding circuit through a redundant circuit 1; and the output voltage of the power-off holding circuit and the output voltages of the 1^{st}, 2^{nd}, ..., m^{th} power circuits supply power to a gate voltage circuit through a redundant circuit 2; and the output of the redundant circuit 2 generates input voltages of 1^{st}, 2^{nd}, ..., m^{th} gate voltage circuits. By detecting a voltage of the power-off holding circuit and voltages of the 1^{st} to n^{th} gate voltage circuits, if a judgment condition is satisfied after a logical judgment, the output voltage of the P1^{st} power circuit supplies power to a power amplifier by means of enable control.

### Alternative Embodiment Seven

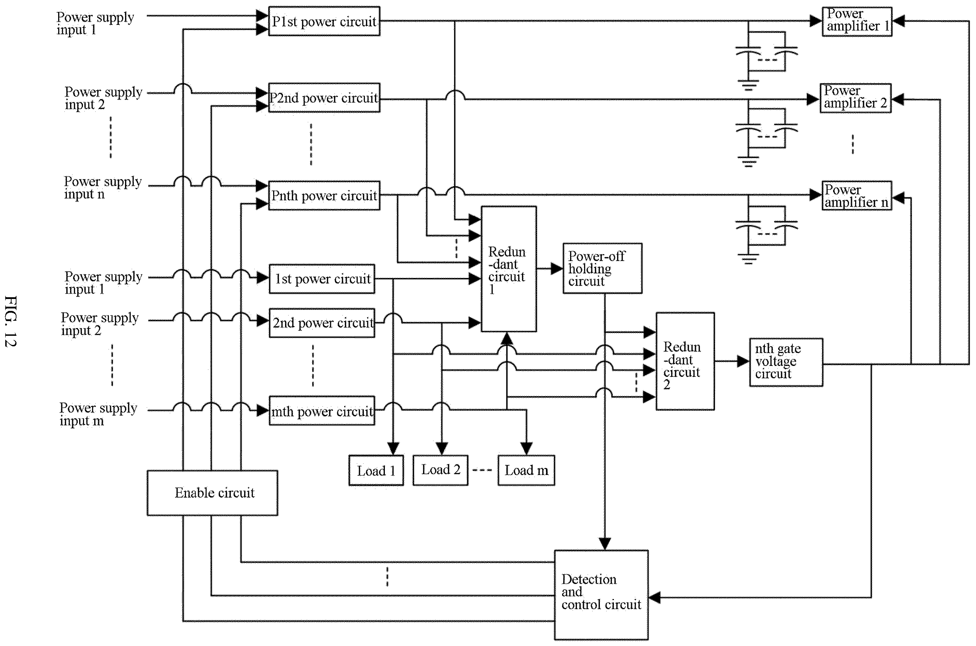

FIG. 12 is a schematic structural diagram of still another power supply apparatus for the power amplifier provided by an embodiment of the present application. The content shown in FIG. 12 is consistent with that described in FIG. 11 except that the output of a redundant circuit 2 generates a gate voltage through an n^{th} gate voltage circuit. In one embodiment, 1^{st}, 2^{nd}, ..., m^{th} power circuits supply power to a digital load of a base station, and P1^{st}, P2^{nd}, ..., Pn^{th} power circuits supply power to the power amplifier. Output voltages of the 1^{st}, 2^{nd}, ..., m^{th} power circuits and output voltages of the P1^{st}, P2^{nd}, ..., Pn^{th} power circuit supply power to a power-off holding circuit through a redundant circuit 1; and an output voltage of the power-off holding circuit and the outputs of the 1^{st}, 2^{nd}, ..., m^{th} power circuits supply power to a gate voltage circuit through a redundant circuit 2; and the output of the redundant circuit 2 generates an input voltage of an n^{th} gate voltage circuit. By detecting a voltage of the power-off holding circuit and a voltage of the n^{th} gate voltage circuit, if a judgment condition is satisfied after a logical judgment, the output voltage of the P1^{st} power circuit supplies power to a power amplifier by means of enable control.

### Alternative Embodiment Eight

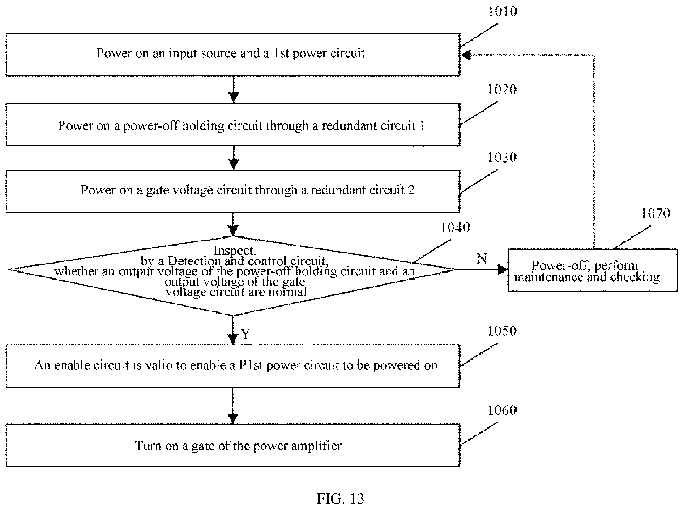

FIG. 13 is a flowchart of power-on control in a power supply apparatus for a power amplifier provided by an embodiment of the present application, which includes the following steps 1010-1070.

At step 1010, an input source is powered on; and a 1^{st} power circuit is powered on.

At step 1020, a power-off holding circuit is powered on through a redundant circuit 1.

At step 1030, a gate voltage circuit is powered on through a redundant circuit 2.

At step 1040, a detection and control circuit inspects whether an output voltage of the power-off holding circuit and an output voltage of the gate voltage circuit are normal; step 1070 is performed in response to a judgment result that any one of the output voltage of the power-off holding circuit and the output voltage of the gate voltage circuit is abnormal; and step 1050 is performed in response to a judgment result that both the output voltage of the power-off holding circuit and the output voltage of the gate voltage circuit are normal.

At step 1050, an enable circuit is valid and enables a P1^{st} power circuit to be powered on.

At step 1060, a gate of the power amplifier is powered on.

At step 1070, power-off for maintenance and check is performed and step 1010 returns to be performed.

### Alternative Embodiment Nine

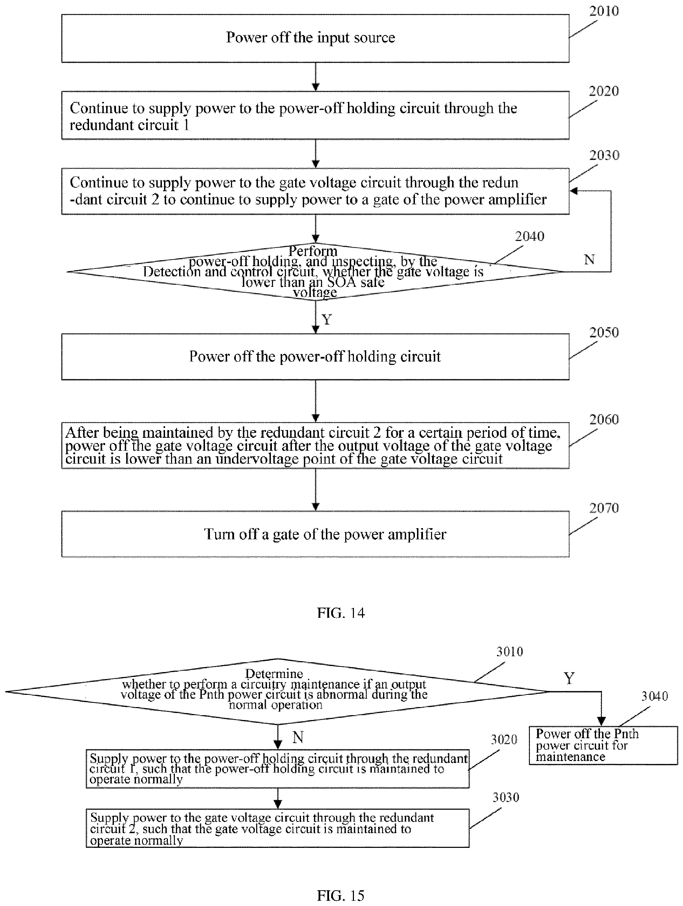

FIG. 14 is a flowchart of power-off control in a power supply apparatus for a power amplifier provided by an embodiment of the present application, which includes the following steps 2010-2070.

At step 2010, an input source is powered off.

At step 2020, a power-off holding circuit is continued to be supplied with power through a redundant circuit 1.

At step 2030, a gate voltage circuit is continued to be supplied with power through a redundant circuit 2 to continue to supply power to a gate of the power amplifier.

At step 2040, power-off holding is performed, and a detection and control circuit inspects whether a gate voltage is lower than an SOA safe voltage; the step 2030 proceeds in response to a judgment result that the gate voltage is higher than the SOA safe voltage of the power amplifier; and step 2050 proceeds in response to a judgment result that the gate voltage is lower than the SOA safe voltage of the power amplifier.

At step 2050, the power-off holding circuit is powered off.

At step 2060, after being maintained by the redundant circuit 2 for a certain period of time, the output voltage of a gate voltage circuit is lower than an undervoltage point of the gate voltage circuit, and the gate voltage circuit is then powered off.

At step 2070, a gate of the power amplifier is turned off.

### Alternative Embodiment Ten

FIG. 15 is a control flowchart showing that the output of a Pn^{th} power circuit is abnormal when a power supply apparatus for a power amplifier provided by an embodiment of the present application operates normally, that is, when any one of the power amplifiers is abnormal, the power supplies of other power amplifiers will not be affected, thereby achieving mutual decoupling and reliability in supplying power.

At step 3010, if an output voltage of the Pn^{th} power circuit is abnormal during the normal operation, it is judged whether to perform a circuitry maintenance; step 3040 proceeds in response to a judgment result of "maintenance"; and step 3020 proceeds in response to a judgment result of "no maintenance".

At step 3020, a power-off holding circuit is supplied with power through a redundant circuit 1, such that the power-off holding circuit is maintained to operate normally.

At step 3030, a gate voltage circuit is supplied with power through a redundant circuit 2, such that the gate voltage circuit is maintained to operate normally.

At step 3040, the Pn^{th} power circuit is powered off for maintenance.

The power-on process of the power supply apparatus for the power amplifier is not affected by input voltages of 1^{st}, 2^{nd}, ..., m^{th} power circuits and P1^{st}, P2^{nd}, ..., Pn^{th} power circuits. The redundant circuits and a detection and control circuit ensure that the P1^{st}, P2^{nd}, ..., Pn^{th} power circuits are enabled if the gate voltage circuit is normal, which reliably realizes the normal power-on requirements of a GaN power amplifier. Meanwhile, the power-off holding circuit is inspected during the power-on process, and the output of the P1^{st} power circuit cannot be started if an abnormality is found. The power-off holding circuit is inspected at the instant of power-on, which ensures that the power-on and power-off timing is more reliable.

The abnormality of any one of 1^{st} to n^{th} gate voltage circuits during the power-on process will not affect the establishment of a gate voltage. The abnormality of any one of the P1^{st} to Pn^{th} power circuits during the power-on process does not affect the establishment of a drain voltage of other normal power amplifiers; if any abnormality is found, power-off for maintenance is performed at any time. Therefore, the power-on inspection ensures the reliability in power-off timing.

The power-off timing is reliable. The redundant circuit 1, the redundant circuit 2 and the power-off holding circuit ensure that the timings can be decoupled from each other without depending on the abnormality and normality of a drain voltage circuit of any power amplifier.

During a normal operation, in the case of abnormality in input (such as a rapid drop or jump of an input voltage caused by lightning surge or battery aging, or a drop of one or more gate voltages caused by abnormal damage of the Pn^{th} power circuit or the n^{th} power circuit), the redundant circuit 1, the redundant circuit 2 and the power-off holding circuit in the present application ensure that the timings of the GaN power amplifier are decoupled from each other without depending on the abnormality and normality of any power supply, which will not cause the paralysis and necessary maintenance of other one or more power supplies, thereby being stable and reliable.

In one embodiment, an output undervoltage point of the gate voltage circuit may be a safe voltage of a GaN gate voltage SOA curve or a voltage value lower than the safe voltage.

### Alternative Embodiment Eleven

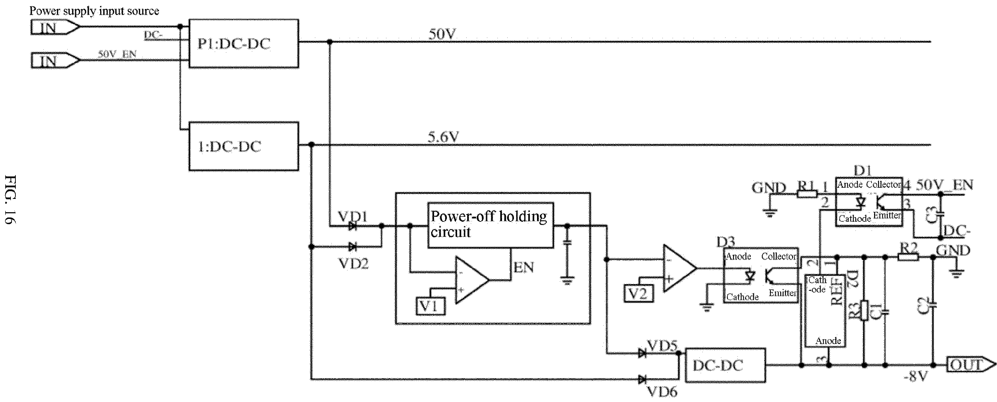

FIG. 16 is a circuit diagram of a power supply apparatus for a power amplifier provided by an embodiment of the present application. A 1^{st} power supply outputs 5.6V for digital power supply after DC-DC conversion, and a P1^{st} power supply outputs 50V after DC-DC conversion to supply power to a drain of the power amplifier. The 1^{st} power supply and the P1^{st} power supply are combined through a diode to supply power to a power-off holding circuit, and the power-off holding circuit and the 1^{st} power supply are combined to generate a gate voltage of -8V through DC-DC. When an output voltage of the power-off holding circuit is greater than V2, it means that the power-off holding circuit is normal; the voltage of -8V reaches a reference point of a comparison circuit at the same time, and the comparison circuit is then turned on; and an optocoupler D1 secondarily enables an isolation module, and the P1^{st} power supply is then powered on.

During the power-off process, the power-off holding circuit maintains the energy so that a gate voltage drops above an SOA safe voltage V1 of a power amplifier, and the gate voltage can still be maintained at -8V. When the drain voltage drops below V1, the 1^{st} power supply is still redundant and then delayed to supply a voltage of -8V until the DC-DC conversion caused by the gate voltage is undervoltage. The gate voltage is powered off to ensure the reliability of sufficient delay during the power-off process.

### Alternative Embodiment Twelve

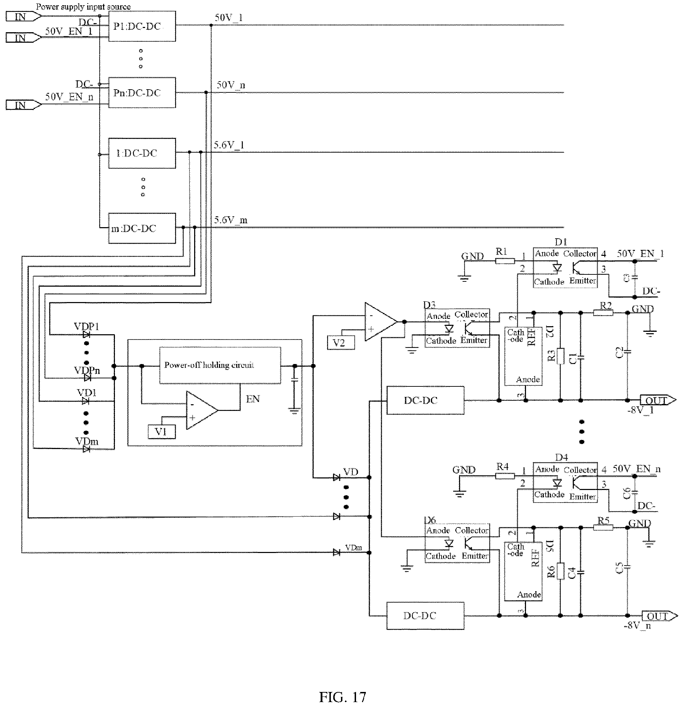

FIG. 17 is a circuit diagram of a power supply apparatus for a plurality of power amplifiers provided by an embodiment of the present application. A 1^{st} power supply outputs 5.6V for digital power supply after DC-DC conversion. A 2^{nd} power supply outputs 5.6Vafter DC-DC conversion to supply power to a digital load of a base station. An m^{th} power supply outputs 5.6V or other voltage after DC-DC conversion to supply power to the digital load of the base station. A P1^{st} power supply outputs 50V after DC-DC conversion to supply power to a drain of the power amplifier. A P2^{nd} power supply outputs 50V after DC-DC conversion to supply power to the drain of the power amplifier. A Pn^{th} power supply outputs 50V after DC-DC conversion to supply power to the drain of the power amplifier. The 1^{st}, 2^{nd}, ...,, m^{th} power supplies and the P1^{st}, P2^{nd}, ..., Pn^{th} power supplies are combined through a diode to supply power to a power-off holding circuit, and the power-off holding circuit and the 1^{st}, 2^{nd}, ...,, m^{th} power supplies are combined to generate gate voltages of -8V1, -8V2, ...,, -8Vn through DC-DC. When an output voltage of the power-off holding circuit is greater than V2, it means that the power-off holding circuit is normal; the voltage of -8V reaches a reference point of a comparison circuit at the same time, and the comparison circuit is then turned on; an optocoupler D1 secondarily enables an isolation module, and the P1^{st}, P2^{nd}, ...,, Pn^{th} power supplies are then powered on. During the power-off process, the power-off holding circuit maintains the energy so that a gate voltage drops above an SOA safe voltage V1 of a power amplifier, and the gate voltage can still be maintained at -8V. When all drain voltages of the P1^{st}, P2^{nd}, ...,, Pn^{th} power supplies drop below V1, the 1^{st} to m^{th} power supplies are still redundant and then delayed to supply a voltage of -8V until the DC-DC is undervoltage. The gate voltage is powered off to ensure the reliability of sufficient delay during the power-off process. V1 is a safe operating voltage of the power amplifier or a voltage value lower than the safe voltage, and V2 is a holding voltage lower than V1, which may be an undervoltage point of the gate voltage or a voltage lower than the undervoltage point.

The alternative Embodiment Eleven and the alternative Embodiment Twelve are only implementation forms of any of the foregoing embodiments, and the present application is not limited to such implementations.

In one embodiment, the present application is also applicable to non-GaN power amplifiers (such as gallium arsenide (GaAs)), as long as they are provided with devices having requirements on power supply timing in the present application.

## Claims

1. A power supply apparatus (310) for a power amplifier, comprising a first power circuit (311), a second power circuit (312), a gate voltage circuit (315), an enable circuit (317), a power-off holding circuit (314) and a detection and control circuit (316),
**characterized in that**:
the power supply apparatus further comprises a redundant circuit (313) connected to the first power circuit (311), the second power circuit (312), the power-off holding circuit (314) and the gate voltage circuit (315), and configured to supply an input voltage to the power-off holding circuit (314) after performing redundancy on an output voltage of the first power circuit (311) and an output voltage of the second power circuit (312), and to supply an input voltage to the gate voltage circuit (315) after performing redundancy on the output voltage of the first power circuit (311) and an output voltage of the power-off holding circuit (314),
wherein the redundancy refers to the realization of "OR" power supply of a plurality of voltages, that is, selectively supplying power, where the plurality of voltages does not affect each other, and the normal operation of the system can be guaranteed as long as at least one of the voltages is normal;
the power-off holding circuit (314) is connected to the gate voltage circuit (315), and configured to provide power-off energy holding and power-off delay to a gate voltage output by the gate voltage circuit (315); and
the detection and control circuit (316) is connected to the power-off holding circuit (314), the gate voltage circuit (315) and the enable circuit (317), and configured to inspect the power-off holding circuit (314) during a power-on process, to detect a voltage of the power-off holding circuit (314) and a voltage of the gate voltage circuit (315) during a normal operation and a power-off process, and to realize, by enable control of the enable circuit (317), where a detection result satisfies a judgment condition, that power-on of the gate voltage is earlier than power-on of a drain voltage output by the second power circuit (312) and that power-off of the gate voltage is later than power-off of the drain voltage output by the second power circuit (312).

2. The apparatus (310) of claim 1, wherein the redundant circuit (313) comprises a first redundant circuit;
a first input terminal of the first redundant circuit is connected to an output terminal of the first power circuit (311);
a second input terminal of the first redundant circuit is connected to an output terminal of the second power circuit (312);
an output terminal of the first redundant circuit is connected to an input terminal of the power-off holding circuit (314), and configured to supply an input voltage to the power-off holding circuit (314);
the first power circuit (311) supplies power to a digital load of a base station; and
the second power circuit (312) supplies power to a drain of the power amplifier.

3. The apparatus (310) of claim 2, wherein the redundant circuit (313) comprises a second redundant circuit;
a first input terminal of the second redundant circuit is connected to the output terminal of the first power circuit (311);
a second input terminal of the second redundant circuit is connected to an output terminal of the power-off holding circuit (314);
an output terminal of the second redundant circuit is connected to the gate voltage circuit (315), and configured to supply an input voltage to the gate voltage circuit (315).

4. The apparatus (310) of any one of claims 1 to 3, wherein the gate voltage circuit (315) is configured to generate a gate voltage for the power amplifier and to supply power to a gate of the power amplifier.

5. The apparatus (310) of any one of claims 1 to 4, wherein a first detection input terminal of the detection and control circuit (316) is connected to an output terminal of the power-off holding circuit (314);
a second detection input terminal of the detection and control circuit (316) is connected to an output terminal of the gate voltage circuit (315); and
an output terminal of the detection and control circuit (316) is connected to an input terminal of the enable circuit (317).

6. The apparatus (310) of any one of claims 1 to 5, wherein an output terminal of the enable circuit (317) is configured to be connected to an enable control circuit of the second power circuit (312) and to perform start control on the second power circuit (312).

7. The apparatus (310) of any one of claims 1 to 6, wherein the first power circuit (311) comprises at least one power supply.

8. The apparatus (310) of any one of claims 1 to 6, wherein the second power circuit (312) comprises at least one power supply.

9. The apparatus (310) of any one of claims 1 to 8, wherein an input source of the first power circuit (311) is same as an input source of the second power circuit (312); or,
an input source of the first power circuit (311) is different from an input source of the second power circuit (312).

10. A power supply method for a power amplifier, **characterized by** comprising:
generating (410), by a redundant circuit (313), a first redundant backup voltage after performing redundancy on an output voltage of a first power circuit (311) and an output voltage of a second power circuit (312), to supply an input voltage to a power-off holding circuit (314);
generating (420), by the redundant circuit, a second redundant backup voltage after performing redundancy on the output voltage of the first power circuit and an output voltage of the power-off holding circuit, to supply an input voltage to a gate voltage circuit (315),
wherein the redundancy refers to the realization of "OR" power supply of a plurality of voltages, that is, selectively supplying power, where the plurality of voltages does not affect each other, and the normal operation of the system can be guaranteed as long as at least one of the voltages is normal;
inspecting (430), by a detection and control circuit, the power-off holding circuit during a power-on process; detecting a voltage of the power-off holding circuit and a voltage of the gate voltage circuit during a normal operation and a power-off process; and realizing (440), by enable control of an enable circuit, where a detection result satisfies a judgment condition, that power-on of the gate voltage output by the gate voltage circuit is earlier than power-on of a drain voltage output by the second power circuit and power-off of the gate voltage output by the gate voltage circuit is later than power-off of the drain voltage output by the second power circuit.

11. The method of claim 10, wherein the first redundant backup voltage is stored in a first redundant circuit, and the second redundant backup voltage is stored in a second redundant circuit;
the step of generating (410), by the redundant circuit, the first redundant backup voltage after performing redundancy on the output voltage of the first power circuit and the output voltage of the second power circuit, to supply the input voltage to the power-off holding circuit comprises:
generating (510), by the first redundant circuit, the first redundant backup voltage after performing redundancy on the output voltage of the first power circuit and the output voltage of the second power circuit, and supplying the first redundant backup voltage to the power-off holding circuit, such that the power-off holding circuit is powered on; and
the step of generating (420), by the redundant circuit, the second redundant backup voltage after performing redundancy on the output voltage of the first power circuit and the output voltage of the power-off holding circuit, to supply the input voltage to the gate voltage circuit comprises:
generating (520), by the second redundant circuit, the second redundant backup voltage after performing redundancy on the output voltage of the first power circuit and the output voltage of the power-off holding circuit, and supplying the second redundant voltage to the gate voltage circuit, such that the gate voltage circuit is powered on.

12. The method of claim 10 or 11, wherein the step of inspecting (430) the power-off holding circuit during the power-on process comprises:
outputting an abnormal signal in response to the detection and control circuit detecting that any one of the output voltage of the power-off holding circuit and the output voltage of the gate voltage circuit is abnormal; and
controlling the enable circuit to be valid in response to the detection and control circuit detecting that each of the output voltage of the power-off holding circuit and the output voltage of the gate voltage circuit is normal.

13. The method of claim 12, wherein the step of controlling the enable circuit to be valid comprises:
controlling, by the detection and control circuit, the enable circuit to enable the second power circuit to be powered on; and
controlling, by the detection and control circuit, the enable circuit to enable a drain of the power amplifier to be turned on.

14. The method of any one of claims 11 to 13, further comprising:
continuing to supply power to the power-off holding circuit by the first redundant circuit; and
continuing to supply power to the gate voltage circuit by the second redundant circuit, to continue to supply power to a gate of the power amplifier.

15. The method of claim 14, wherein the step of detecting the output voltage of the power-off holding circuit and the output voltage of the gate voltage circuit during the power-off process comprises:
continuing to supply power to the first redundant circuit in response to the detection and control circuit detecting that a gate voltage is higher than a safe voltage of the power amplifier; and,
powering off the gate voltage circuit in response to the detection and control circuit detecting that an output voltage of the gate voltage circuit is lower than an undervoltage point of the gate voltage circuit.

## Patentansprüche

1. Stromversorgungsvorrichtung (310) für einen Leistungsverstärker, die eine erste Leistungsschaltung (311), eine zweite Leistungsschaltung (312), eine Gate-Spannungsschaltung (315), eine Freigabeschaltung (317), eine Ausschalt-Halteschaltung (314) und eine Detektions- und Steuerschaltung (316) umfasst,
**dadurch gekennzeichnet, dass**:
die Stromversorgungsvorrichtung ferner eine redundante Schaltung (313) umfasst, die mit der ersten Leistungsschaltung (311), der zweiten Leistungsschaltung (312), der Ausschalt-Halteschaltung (314) und der Gate-Spannungsschaltung (315) verbunden ist und dazu ausgelegt ist, eine Eingangsspannung an die Ausschalt-Halteschaltung (314) nach Durchführen einer Redundanz an einer Ausgangsspannung der ersten Leistungsschaltung (311) und einer Ausgangsspannung der zweiten Leistungsschaltung (312) zu liefern, und eine Eingangsspannung an die Gate-Spannungsschaltung (315) nach Durchführen einer Redundanz an der Ausgangsspannung der ersten Leistungsschaltung (311) und einer Ausgangsspannung der Ausschalt-Halteschaltung (314) zu liefern,
wobei sich die Redundanz auf die Realisierung einer "ODER"-Stromversorgung mehrerer Spannungen bezieht, das heißt, selektives Zuführen von Leistung, wobei sich die mehreren Spannungen nicht gegenseitig beeinflussen, und der normale Betrieb des Systems garantiert werden kann, solange mindestens eine der Spannungen normal ist;
die Ausschalt-Halteschaltung (314) mit der Gate-Spannungsschaltung (315) verbunden und dazu ausgelegt ist, Ausschaltenergieerhaltung und Ausschaltverzögerung an eine Gate-Spannung bereitzustellen, die durch die Gate-Spannungsschaltung (315) ausgegeben wird; und
die Detektions- und Steuerschaltung (316) mit der Ausschalt-Halteschaltung (314), der Gate-Spannungsschaltung (315) und der Freigabeschaltung (317) verbunden ist und dazu ausgelegt ist, die Ausschalt-Halteschaltung (314) während eines Einschaltprozesses zu inspizieren, um eine Spannung der Ausschalt-Halteschaltung (314) und eine Spannung der Gate-Spannungsschaltung (315) während eines normalen Betriebs und eines Ausschaltprozesses zu detektieren, und um durch Aktivieren einer Steuerung der Freigabeschaltung (317), bei der ein Detektionsergebnis eine Beurteilungsbedingung erfüllt, zu realisieren, dass ein Einschalten der Gate-Spannung früher als ein Einschalten einer Drain-Spannung ist, die durch die zweite Leistungsschaltung (312) ausgegeben wird, und dass ein Ausschalten der Gate-Spannung später als ein Ausschalten der Drain-Spannung ist, die durch die zweite Leistungsschaltung (312) ausgegeben wird.

2. Vorrichtung (310) nach Anspruch 1, wobei die redundante Schaltung (313) eine erste redundante Schaltung umfasst;
ein erster Eingangsanschluss der ersten redundanten Schaltung mit einem Ausgangsanschluss der ersten Leistungsschaltung (311) verbunden ist;
ein zweiter Eingangsanschluss der ersten redundanten Schaltung mit einem Ausgangsanschluss der zweiten Leistungsschaltung (312) verbunden ist;
ein Ausgangsanschluss der ersten redundanten Schaltung mit einem Eingangsanschluss der Ausschalt-Halteschaltung (314) verbunden ist und dazu ausgelegt ist, eine Eingangsspannung an die Ausschalt-Halteschaltung (314) zu liefern;
die erste Leistungsschaltung (311) eine digitale Last einer Basisstation mit Leistung versorgt; und
die zweite Leistungsschaltung (312) einen Drain des Leistungsverstärkers mit Leistung versorgt.

3. Vorrichtung (310) nach Anspruch 2, wobei die redundante Schaltung (313) eine zweite redundante Schaltung umfasst;
ein erster Eingangsanschluss der zweiten redundanten Schaltung mit dem Ausgangsanschluss der ersten Leistungsschaltung (311) verbunden ist;
ein zweiter Eingangsanschluss der zweiten redundanten Schaltung mit einem Ausgangsanschluss der Ausschalt-Halteschaltung (314) verbunden ist;
ein Ausgangsanschluss der zweiten redundanten Schaltung mit der Gate-Spannungsschaltung (315) verbunden und dazu ausgelegt ist, eine Eingangsspannung an die Gate-Spannungsschaltung (315) zu liefern.

4. Vorrichtung (310) nach einem der Ansprüche 1 bis 3, wobei die Gate-Spannungsschaltung (315) dazu ausgelegt ist, eine Gate-Spannung für den Leistungsverstärker zu erzeugen und Leistung an ein Gate des Leistungsverstärkers zu liefern.

5. Vorrichtung (310) nach einem der Ansprüche 1 bis 4, wobei ein erster Detektionseingangsanschluss der Detektions- und Steuerschaltung (316) mit einem Ausgangsanschluss der Ausschalt-Halteschaltung (314) verbunden ist;
ein zweiter Detektionseingangsanschluss der Detektions- und Steuerschaltung (316) mit einem Ausgangsanschluss der Gate-Spannungsschaltung (315) verbunden ist; und
ein Ausgangsanschluss der Detektions- und Steuerschaltung (316) mit einem Eingangsanschluss der Freigabeschaltung (317) verbunden ist.

6. Vorrichtung (310) nach einem der Ansprüche 1 bis 5, wobei ein Ausgangsanschluss der Freigabeschaltung (317) dazu ausgelegt ist, mit einer Freigabesteuerschaltung der zweiten Leistungsschaltung (312) verbunden zu werden und eine Startsteuerung an der zweiten Leistungsschaltung (312) durchzuführen.

7. Vorrichtung (310) nach einem der Ansprüche 1 bis 6, wobei die erste Leistungsschaltung (311) mindestens eine Stromversorgung umfasst.

8. Vorrichtung (310) nach einem der Ansprüche 1 bis 6, wobei die zweite Leistungsschaltung (312) mindestens eine Stromversorgung umfasst.

9. Vorrichtung (310) nach einem der Ansprüche 1 bis 8, wobei eine Eingangsquelle der ersten Leistungsschaltung (311) gleich einer Eingangsquelle der zweiten Leistungsschaltung (312) ist; oder,
eine Eingangsquelle der ersten Leistungsschaltung (311) sich von einer Eingangsquelle der zweiten Leistungsschaltung (312) unterscheidet.

10. Stromversorgungsverfahren für einen Leistungsverstärker, **dadurch gekennzeichnet, dass** es Folgendes umfasst:
Erzeugen (410), durch eine redundante Schaltung (313), einer ersten redundanten Reservespannung nach Durchführen einer Redundanz an einer Ausgangsspannung einer ersten Leistungsschaltung (311) und einer Ausgangsspannung einer zweiten Leistungsschaltung (312), um eine Eingangsspannung an eine Ausschalt-Halteschaltung (314) zu liefern;
Erzeugen (420), durch die redundante Schaltung, einer zweiten redundanten Reservespannung nach Durchführen einer Redundanz an der Ausgangsspannung der ersten Leistungsschaltung und einer Ausgangsspannung der Ausschalt-Halteschaltung, um eine Eingangsspannung an eine Gate-Spannungsschaltung (315) zu liefern,
wobei sich die Redundanz auf die Realisierung einer "ODER"-Stromversorgung mehrerer Spannungen bezieht, das heißt, selektives Zuführen von Leistung, wobei sich die mehreren Spannungen nicht gegenseitig beeinflussen, und der normale Betrieb des Systems garantiert werden kann, solange mindestens eine der Spannungen normal ist;
Inspizieren (430), durch eine Detektions- und Steuerschaltung, der Ausschalt-Halteschaltung während eines Einschaltvorgangs; Detektieren einer Spannung der Ausschalt-Halteschaltung und einer Spannung der Gate-Spannungsschaltung während eines normalen Betriebs und eines Ausschaltvorgangs; und Realisieren (440), durch Freigeben einer Steuerung einer Freigabeschaltung, bei der ein Detektionsergebnis eine Beurteilungsbedingung erfüllt, dass ein Einschalten der Gate-Spannung, die durch die Gate-Spannungsschaltung ausgegeben wird, früher ist als ein Einschalten einer Drain-Spannung, die durch die zweite Leistungsschaltung ausgegeben wird, und ein Ausschalten der Gate-Spannung, die durch die Gate-Spannungsschaltung ausgegeben wird, später ist als ein Ausschalten der Drain-Spannung, die durch die zweite Leistungsschaltung ausgegeben wird.

11. Verfahren nach Anspruch 10, wobei die erste redundante Reservespannung in einer ersten redundanten Schaltung gespeichert wird und die zweite redundante Reservespannung in einer zweiten redundanten Schaltung gespeichert wird;
der Schritt des Erzeugens (410), durch die redundante Schaltung, der ersten redundanten Reservespannung nach Durchführen einer Redundanz an der Ausgangsspannung der ersten Leistungsschaltung und der Ausgangsspannung der zweiten Leistungsschaltung, um die Eingangsspannung an die Ausschalt-Halteschaltung zu liefern, Folgendes umfasst:
Erzeugen (510), durch die erste redundante Schaltung, der ersten redundanten Reservespannung nach Durchführen einer Redundanz an der Ausgangsspannung der ersten Leistungsschaltung und der Ausgangsspannung der zweiten Leistungsschaltung, und Liefern der ersten redundanten Reservespannung an die Ausschalt-Halteschaltung, so dass die Ausschalt-Halteschaltung eingeschaltet wird; und
der Schritt des Erzeugens (420), durch die redundante Schaltung, der zweiten redundanten Reservespannung nach Durchführen einer Redundanz an der Ausgangsspannung der ersten Leistungsschaltung und der Ausgangsspannung der Ausschalt-Halteschaltung, um die Eingangsspannung an die Gate-Spannungsschaltung zu liefern, Folgendes umfasst:
Erzeugen (520), durch die zweite redundante Schaltung, der zweiten redundanten Reservespannung nach Durchführen einer Redundanz an der Ausgangsspannung der ersten Leistungsschaltung und der Ausgangsspannung der Ausschalt-Halteschaltung, und Liefern der zweiten redundanten Spannung an die Gate-Spannungsschaltung, so dass die Gate-Spannungsschaltung eingeschaltet wird.

12. Verfahren nach Anspruch 10 oder 11, wobei der Schritt des Inspizierens (430) der Ausschalt-Halteschaltung während des Einschaltprozesses Folgendes umfasst:
Ausgeben eines anormalen Signals als Reaktion darauf, dass die Detektions- und Steuerschaltung detektiert, dass eine beliebige der Ausgangsspannung der Ausschalt-Halteschaltung und der Ausgangsspannung der Gate-Spannungsschaltung anormal ist; und
Steuern der Freigabeschaltung, damit sie gültig ist, als Reaktion darauf, dass die Steuerschaltung erkennt, dass sowohl die Ausgangsspannung der Ausschalt-Halteschaltung als auch die Ausgangsspannung der Gate-Spannungsschaltung normal ist.

13. Verfahren nach Anspruch 12, wobei der Schritt des Steuerns der Freigabeschaltung, gültig zu sein, Folgendes umfasst:
Steuern, durch die Detektions- und Steuerschaltung, der Freigabeschaltung, um zu ermöglichen, dass die zweite Leistungsschaltung eingeschaltet wird; und
Steuern, durch die Detektions- und Steuerschaltung, der Freigabeschaltung, um zu ermöglichen, dass ein Drain des Leistungsverstärkers eingeschaltet wird.

14. Verfahren nach einem der Ansprüche 11 bis 13, das ferner Folgendes umfasst:
Fortsetzen der Stromversorgung der Ausschalt-Halteschaltung durch die erste redundante Schaltung; und Fortsetzen der Stromversorgung der Gate-Spannungsschaltung durch die zweite redundante Schaltung, um die Stromversorgung eines Gates des Leistungsverstärkers fortzusetzen.

15. Verfahren nach Anspruch 14, wobei der Schritt des Detektierens der Ausgangsspannung der Ausschalt-Halteschaltung und der Ausgangsspannung der Gate-Spannungsschaltung während des Ausschaltprozesses Folgendes umfasst:
Fortsetzen der Stromversorgung der ersten redundanten Schaltung als Reaktion darauf, dass die Detektions- und Steuerschaltung erkennt, dass eine Gate-Spannung höher als eine sichere Spannung des Leistungsverstärkers ist; und,
Ausschalten der Gate-Spannungsschaltung als Reaktion darauf, dass die Detektions- und Steuerschaltung detektiert, dass eine Ausgangsspannung der Gate-Spannungsschaltung niedriger als ein Unterspannungspunkt der Gate-Spannungsschaltung ist.

## Revendications

1. Appareil d'alimentation électrique (310) pour un amplificateur de puissance, comprenant un premier circuit d'alimentation (311), un second circuit d'alimentation (312), un circuit de tension de grille (315), un circuit de validation (317), un circuit de maintien hors tension (314) et un circuit de détection et de commande (316),
**caractérisé en ce que** :
l'appareil d'alimentation électrique comprend en outre un circuit redondant (313) connecté au premier circuit d'alimentation (311), au second circuit d'alimentation (312), au circuit de maintien hors tension (314) et au circuit de tension de grille (315) et configuré pour fournir une tension d'entrée au circuit de maintien hors tension (314) après avoir réalisé une redondance sur une tension de sortie du premier circuit d'alimentation (311) et une tension de sortie du second circuit d'alimentation (312) et pour fournir une tension d'entrée au circuit de tension de grille (315) après avoir réalisé une redondance sur la tension de sortie du premier circuit d'alimentation (311) et une tension de sortie du circuit de maintien hors tension (314),
la redondance faisant référence à la réalisation d'une alimentation « OU » d'une pluralité de tensions, c'est-à-dire une alimentation sélective, la pluralité de tensions ne s'affectant pas mutuellement, et le fonctionnement normal du système pouvant être garanti tant qu'au moins une des tensions est normale ;
le circuit de maintien hors tension (314) est connecté au circuit de tension de grille (315) et configuré pour fournir un maintien d'énergie hors tension et un retard de mise hors tension à une tension de grille délivrée en sortie par le circuit de tension de grille (315) ; et
le circuit de détection et de commande (316) est connecté au circuit de maintien hors tension (314), au circuit de tension de grille (315) et au circuit de validation (317) et configuré pour inspecter le circuit de maintien hors tension (314) pendant un processus de mise sous tension, pour détecter une tension du circuit de maintien hors tension (314) et une tension du circuit de tension de grille (315) pendant un fonctionnement normal et un processus de mise hors tension et pour déterminer, par une commande de validation du circuit de validation (317), lorsqu'un résultat de détection satisfait à une condition de jugement, qu'une mise sous tension de la tension de grille est antérieure à une mise sous tension d'une tension de drain délivrée en sortie par le second circuit d'alimentation (312) et qu'une mise hors tension de la tension de grille est postérieure à une mise hors tension de la tension de drain délivrée en sortie par le second circuit d'alimentation (312).

2. Appareil (310) selon la revendication 1, le circuit redondant (313) comprenant un premier circuit redondant ;
une première borne d'entrée du premier circuit redondant étant connectée à une borne de sortie du premier circuit d'alimentation (311) ;
une seconde borne d'entrée du premier circuit redondant étant connectée à une borne de sortie du second circuit d'alimentation (312) ;
une borne de sortie du premier circuit redondant étant connectée à une borne d'entrée du circuit de maintien hors tension (314) et configurée pour fournir une tension d'entrée au circuit de maintien hors tension (314) ;
le premier circuit d'alimentation (311) alimentant une charge numérique d'une station de base ; et
le second circuit d'alimentation (312) alimentant un drain de l'amplificateur de puissance.

3. Appareil (310) selon la revendication 2, le circuit redondant (313) comprenant un second circuit redondant ; une première borne d'entrée du second circuit redondant étant connectée à la borne de sortie du premier circuit d'alimentation (311) ;
une seconde borne d'entrée du second circuit redondant étant connectée à une borne de sortie du circuit de maintien hors tension (314) ;
une borne de sortie du second circuit redondant étant connectée au circuit de tension de grille (315) et configurée pour fournir une tension d'entrée au circuit de tension de grille (315).

4. Appareil (310) selon l'une quelconque des revendications 1 à 3, le circuit de tension de grille (315) étant configuré pour générer une tension de grille pour l'amplificateur de puissance et pour alimenter une grille de l'amplificateur de puissance.

5. Appareil (310) selon l'une quelconque des revendications 1 à 4, une première borne d'entrée de détection du circuit de détection et de commande (316) étant connectée à une borne de sortie du circuit de maintien hors tension (314) ;
une seconde borne d'entrée de détection du circuit de détection et de commande (316) étant connectée à une borne de sortie du circuit de tension de grille (315) ; et
une borne de sortie du circuit de détection et de commande (316) étant connectée à une borne d'entrée du circuit de validation (317).

6. Appareil (310) selon l'une quelconque des revendications 1 à 5, une borne de sortie du circuit de validation (317) étant configurée pour être connectée à un circuit de commande de validation du second circuit d'alimentation (312) et pour réaliser une commande de démarrage sur le second circuit d'alimentation (312).

7. Appareil (310) selon l'une quelconque des revendications 1 à 6, le premier circuit d'alimentation (311) comprenant au moins une alimentation électrique.

8. Appareil (310) selon l'une quelconque des revendications 1 à 6, le second circuit d'alimentation (312) comprenant au moins une alimentation électrique.

9. Appareil (310) selon l'une quelconque des revendications 1 à 8, une source d'entrée du premier circuit d'alimentation (311) étant la même qu'une source d'entrée du second circuit d'alimentation (312) ; ou une source d'entrée du premier circuit d'alimentation (311) étant différente d'une source d'entrée du second circuit d'alimentation (312).

10. Procédé d'alimentation électrique pour un amplificateur de puissance, **caractérisé en ce qu'**il comprend les étapes consistant à :
générer (410), par un circuit redondant (313), une première tension de secours redondante après avoir réalisé une redondance sur une tension de sortie d'un premier circuit d'alimentation (311) et une tension de sortie d'un second circuit d'alimentation (312), pour fournir une tension d'entrée à un circuit de maintien hors tension (314) ;
générer (420), par le circuit redondant, une seconde tension de secours redondante après avoir réalisé une redondance sur la tension de sortie du premier circuit d'alimentation et une tension de sortie du circuit de maintien hors tension, pour fournir une tension d'entrée à un circuit de tension de grille (315),
la redondance faisant référence à la réalisation d'une alimentation « OU » d'une pluralité de tensions, c'est-à-dire une alimentation sélective, la pluralité de tensions ne s'affectant pas mutuellement, et le fonctionnement normal du système pouvant être garanti tant qu'au moins une des tensions est normale ;
inspecter (430), par un circuit de détection et de commande, le circuit de maintien hors tension pendant un processus de mise sous tension ; détecter une tension du circuit de maintien hors tension et une tension du circuit de tension de grille pendant un fonctionnement normal et un processus de mise hors tension ; et déterminer (440), par une commande de validation d'un circuit de validation, lorsqu'un résultat de détection satisfait à une condition de jugement, qu'une mise sous tension de la tension de grille délivrée en sortie par le circuit de tension de grille est antérieure à une mise sous tension d'une tension de drain délivrée en sortie par le second circuit d'alimentation et que la mise hors tension de la tension de grille délivrée en sortie par le circuit de tension de grille est postérieure à la mise hors tension de la tension de drain délivrée en sortie par le second circuit d'alimentation.

11. Procédé selon la revendication 10, la première tension de secours redondante étant stockée dans un premier circuit redondant et la seconde tension de secours redondante étant stockée dans un second circuit redondant ;
l'étape de génération (410), par le circuit redondant, de la première tension de secours redondante après avoir réalisé une redondance sur la tension de sortie du premier circuit d'alimentation et la tension de sortie du second circuit d'alimentation, pour fournir la tension d'entrée au circuit de maintien hors tension, comprenant les étapes consistant à :
générer (510), par le premier circuit redondant, la première tension de secours redondante après avoir réalisé une redondance sur la tension de sortie du premier circuit d'alimentation et la tension de sortie du second circuit d'alimentation, et fournir la première tension de secours redondante au circuit de maintien hors tension, de telle sorte que le circuit de maintien hors tension soit mis sous tension ; et
l'étape de génération (420), par le circuit redondant, de la seconde tension de secours redondante après avoir réalisé une redondance sur la tension de sortie du premier circuit d'alimentation et la tension de sortie du circuit de maintien hors tension, pour fournir la tension d'entrée au circuit de tension de grille, comprenant les étapes consistant à :
générer (520), par le second circuit redondant, la seconde tension de secours redondante après avoir réalisé une redondance sur la tension de sortie du premier circuit d'alimentation et la tension de sortie du circuit de maintien hors tension, et fournir la seconde tension redondante au circuit de tension de grille, de telle sorte que le circuit de tension de grille soit mis sous tension.

12. Procédé selon la revendication 10 ou 11, l'étape d'inspection (430) du circuit de maintien hors tension pendant le processus de mise sous tension comprenant les étapes consistant à :
délivrer en sortie un signal d'anomalie en réponse à la détection, par le circuit de détection et de commande, qu'une quelconque des tensions de sortie du circuit de maintien hors tension et du circuit de tension de porte est anormale ; et
commander le circuit de validation pour qu'il soit valide en réponse à la détection, par le circuit de détection et de commande, que chacune des tensions de sortie du circuit de maintien hors tension et du circuit de tension de porte est normale.

13. Procédé selon la revendication 12, l'étape de commande du circuit de validation pour qu'il soit valide comprenant les étapes consistant à :
commander, par le circuit de détection et de commande, le circuit de validation pour valider la mise sous tension du second circuit d'alimentation ; et
commander, par le circuit de détection et de commande, le circuit de validation pour valider la mise sous tension d'un drain de l'amplificateur de puissance.

14. Procédé selon l'une quelconque des revendications 11 à 13, comprenant en outre les étapes consistant à :
continuer d'alimenter le circuit de maintien hors tension par le premier circuit redondant ; et
continuer d'alimenter le circuit de tension de grille par le second circuit redondant, afin de continuer d'alimenter une grille de l'amplificateur de puissance.

15. Procédé selon la revendication 14, l'étape de détection de la tension de sortie du circuit de maintien hors tension et de la tension de sortie du circuit de tension de grille pendant le processus de mise hors tension comprenant les étapes consistant à :
continuer d'alimenter le premier circuit redondant en réponse à la détection, par le circuit de détection et de commande, qu'une tension de grille est supérieure à une tension de sécurité de l'amplificateur de puissance ; et
mettre hors tension le circuit de tension de grille en réponse à la détection, par le circuit de détection et de commande, qu'une tension de sortie du circuit de tension de grille est inférieure à un point de sous-tension du circuit de tension de grille.
